Europäisches Patentamt

(19) European Patent Office

Office européen des brevets

(11) Publication number: **0 090 186**
**B1**

(12) EUROPEAN PATENT SPECIFICATION

(45) Date of publication of patent specification: 04.11.87

(51) Int. Cl.⁴: **H 03 K 19/082**

(21) Application number: 83101932.8

(22) Date of filing: 28.02.83

(54) Complementary logic circuit.

(30) Priority: 29.03.82 US 363166

(43) Date of publication of application:
05.10.83 Bulletin 83/40

(45) Publication of the grant of the patent:
04.11.87 Bulletin 87/45

(84) Designated Contracting States:
DE FR GB

(56) References cited:
DE-A-2 451 579
US-A-3 518 449

IBM TECHNICAL DISCLOSURE BULLETIN, vol.
24, no. 1B, June 1981, page 511, New York,
USA; H. BERANGER et al.: "Emitter coupled
logic gate with a dual current source"

(73) Proprietor: International Business Machines
Corporation
Old Orchard Road
Armonk, N.Y. 10504 (US)

(72) Inventor: Montegari, Frank Alfred
Van Voorhis Terrace
Wappingers Falls New York 12590 (US)

(74) Representative: Gaugel, Heinz, Dipl.-Ing.
Schönaicher Strasse 220
D-7030 Böblingen (DE)

Courier Press, Leamington Spa, England.

# 0 090 186

**Description**

The invention relates to a logical binary circuitry and circuitry having particular utility as a decode circuit for use in solid-state matrix memory arrays such as a PROM, ROM or RAM.

Solid-state matrix memory arrays in which information is stored are well known in the art. The matrix array, as a single integrated circuit comprises rows and columns of parallel electrical conductors formed with memory cells (or memory elements) connecting the intersections or cross-over points of the rows and columns. The RAM will have a memory cell at each cross-over point, whereas the ROM will have a memory element at, at least certain cross-over points. The complementary address decode circuitry, in accordance with the invention finds particular utility when employed in the circuitry utilized to address a matrix memory array.

It will be readily appreciated by persons skilled in the art, by virtue of the detailed description set forth hereinafter, that the circuitry of the invention may be employed in applications other than matrix memories. It will further be apparent, from the detailed description hereinafter, that a portion or all of the complementary address decode circuit in accordance with the invention may be employed as a binary logic circuit for accepting a pluraity of binary inputs and providing one or more logical binary outputs which are respectively logical binary functions of said inputs.

Numerous decode circuits and binary logical circuits are known to the art. The following patents and publications are not necessarily fully representative of the art. It is to be appreciated, with reference to the subject invention, that the following art is not submitted to be the only prior art, the best prior art, or the most pertinent prior art.

Accordingly, it is an object of this invention to provide an improved decode circuit and logic circuit.

Reference is made to U.S. Patent No. 2,964,652 entitled "Transistor Switching Circuits" granted December 13, 1960 to H. S. Yourke. The Yourke patent is directed to transistor circuitry for switching applications where the advantages of the grounded base type of operation are utilized to provide a maximum of switching speed. This is accomplished by providing a transistor switching circuit having a common point to which is attached a constant current source. Multiple current paths are provided between the common point and the reference potential, each of which has an asymmetric impedance and at least one of which is a transistor. With this configuration a difference of potential may be applied between points in the paths to control the path through which the constant current flows.

Reference is made to U.S. Patent No. 3,040,192 entitled "Logic, Exclusive-OR, and Shift Register Circuits Utilizing Directly Connected Cascade Transistors in "Tree" Configuration" granted June 19, 1962 to E. J. Slobodzinski. The Slobodzinski patent is directed to direct coupled transistor circuits. The circuits operate at speeds limited only by the parameters of the transistors themselves. By utilizing the principles of the invention, circuits of many different types may be achieved with each capable of operation at the high speeds heretofore mentioned. More particularly and in its simplest form, a circuit embodying the invention makes use of three pairs of transistors. These transistors are connected with suitable biasing means and so arranged that when a transistor of a first input pair is rendered conductive, the other transistor of that pair is rendered non-conductive, and vice versa. A single-applying means, representative of a variable "A", is associated with at least one such transistor. The input electrodes of a second pair of the transistors are interconnected; and so are the input electrodes of a third pair of the transistors. An output connection is provided from each of the transistors of said first pair. One of said output connections interconnects an input transistor and the input electrodes of the second pair of transistors, while the other of them interconnects the other input transistor and the input electrodes of the third pair of transistors. A control electrode of one transistor of each of said second and third pairs is connected to a source of reference potential, while input signal-applying circuits are provided for the control electrodes of the remaining transistors of the second and third pairs. Output circuits extend from selected transistors of the latter pairs. Where there is an output circuit from each transistor of each of the second and third pairs, and where a signal representative of a variable "B" is applied to the interconnected control electrodes of a transistor in each of said second and third pairs, the outputs will be respectively representative of A B, A $\overline{B}$, $\overline{A}$ $\overline{B}$, and $\overline{A}$ B. With selected outputs, or more particularly, by interconnecting selected outputs, an EXCLUSIVE-OR circuit is formed, etc.

Reference is made to U.S. Patent No. 3,259,761 entitled "Integrated Circuit Logic" granted July 5, 1966 to J. A. Narud et al. The Narud et al. patent is directed to integrated circuit logic of the current switch type wherein only a conductivity type transistor is employed.

Reference is made to U.S. Patent No. 3,337,748 entitled "Low Dissipation Inductance Drivers" granted August 22, 1967 to W. T. Rusch et al. The Rusch et al. patent is directed to a low dissipation or "loss-less" inductance driver. The circuit is of general application to any system wherein a current is supplied to an inductive load, which current may be required to increase or decrease in accordance with time and/or load requirements, and to remain at a certain level, which may increase or decrease with time and/or load conditions, for a required period.

Reference is made to U.S. Patent No. 3,610,949 entitled "Circuit for Performing Logic Functions" granted October 5, 1971 to D. Armgarth. The Armgarth patent is directed to a logic circuit in which a separate resistor is connected between the parallel-connected collectors of the input transistors, i.e., the junction point, and each circuit output. The terminals of the resistors connected to the junction point are

2

also connected to the bases of the corresponding output transistors, and the other resistor terminals are connected to the emitters of the corresponding output transistors. The collectors of the output transistors are grounded, and the output transistors and input transistors are of complementary type.

Reference is made to U.S. Patent No. 3,816,758 entitled "Digital Logic Circuit" granted June 11, 1974 to H. H. Berger et al. The monolithic semiconductor circuit for a logic circuit concept of high packing density is characterized in that a semiconductor body of a first conductivity comprises at least two regions of opposite conductivity, which are spaced in relation to each other, as emitter and collector zones of a lateral transistor structure, that the collector zone of the lateral transistor structure incorporates at least one further zone of opposite conductivity as a collector zone of an inversely operated vertical transistor structure, and that for the operation of this semiconductor structure as a basic logic circuit a current flow is impressed in the emitter zone of the lateral transistor structure, which as a function of the input signal applied to its collector zone, controls the current flow, serving as an output signal, through the vertical transistor structure.

Reference is made to U.S. Patent No. 3,863,230 entitled "MOS Memory Decoder Circuit" granted January 28, 1975 to W. M. Regitz. A decoder circuit for an MOS memory array which utilizes a single clock or timing circuit is described. The address to a decoder circuit is first applied to an inverter buffer which inverts the address and provides inverted address outputs which are synchronized with the timing signal. A feedback loop within each inverter maintains an output at the inverter for the remainder of each timing frame even though the input address has been removed. The output from the inverters are coupled to a plurality of logic decoders. Each logic decoder comprises a plurality of MOS devices, some of which are coupled in series, and the remainder of which are coupled in parallel. The series and parallel combination of these devices are utilized for providing an output signal when the proper address is applied to the logic decoder. In the presently preferred embodiment, each logic decoder is used for activating either a column of the array or a line of the array. Each such logic decoder is structurally different and this difference in structure determines the logic function performed by each of the logic decoders. Each logic decoder also includes a bootstrap circuit for bootstrapping an output MOS device such that the output from the logic decoder approaches the potential applied to the decoder.

Reference is made to U.S. Patent No. 3,911,428 entitled "Decode Circuit" granted October 7, 1975 to W. B. Chin. A decode circuit for use in a decoder employing switches such as complementary metal oxide semiconductor (CMOS) field effect transistors, utilizing cascaded (series-connected) switches of one channel type and a pair of cascoded (parallel-connected) switches of the opposite channel type. In the quiescent state, the output lines of the decode circuits are clamped to ground to assure that substantially no power is dissipated. When the decoder system is in the select state, the output lines of the unselected decode circuits remain clamped to ground. The circuit has the advantage that it requires only a pair of cascoded switches plus a strobe switch connected in series with the data switches for operation. This results in a considerable savings of the devices required over prior art decode circuits of this type.

Reference is made to U.S. Patent No. 3,914,620 entitled "Decode Circuitry for Bipolar Random Access Memory" granted October 21, 1975 to H. S. Millhollan et al. An N-bit binary address decoder suitable for use in an emitter-coupled logic bipolar random access memory (RAM) is provided. Each of the N address input signals is applied to an input terminal and is level shifted and applied to the input node of an emitter-coupled logic inverter. The outputs of the emitter-coupled logic inverter are the collectors of the emitter-coupled transistors on which complementary output signals representative of the corresponding binary address input signal are produced. The complementary output signals generated by the N inverters are connected to $2^N$ AND gates to form the possible $2^N$ minterm combinations. Each of the AND gates includes a load resistor coupled to a power supply and N Schottky diodes having their anodes coupled to the load resistor and their cathodes coupled to the corresponding address inverter output terminals. The anodes of the input diodes of each AND gate are also connected to the base of a transistor, the emitter of which produces the signal representing the corresponding minterm function generated by that AND gate.

Reference is made to U.S. Patent No. 3,916,215 entitled "Programmable ECL Threshold Logic Gate" granted October 28, 1975 to J. R. Gaskill et al. A decoupling technique useful in the mechanization of some logic family devices is disclosed. The procedure involves the insertion of a common base transistor between a collector node at which several collectors may be connected and the load resistor for the output device. In general, the emitter of the common base decoupling transistor is connected into the collector node and the collector of the common base decoupling transistor is connected to the output load resistor. The impedance thus presented at the collector node by the common base emitter is very much smaller than the load resistance and as a result, the collector time constant becomes relatively insignificant compared with other time constants in the circuit. Practical realization of differential current threshold programming is thus made possible through the implementation of the decoupling techniques of the invention.

Reference is made to U.S. Patent No. 3,916,218 entitled "Integrated Power Supply for Merged Transistor Logic Circuit" granted October 28, 1975 to H. H. Berger et al. A monolithically integrated device including a binary logic circuit and a power supply for said logic circuit. The binary logic circuit comprising at least one basic circuit consisting essentially of two interconnected complementary transistors, where the base of the first inversely operated transistor is connected to the collector of second transistor, and where the emitter of the first transistor is connected to the base of the second transistor. The power supply of said device being connected to the emitter of the second transistor of said basic circuit. The power supply providing a current to said emitter of said second transistor of said basic circuit which, in accordance with an input signal applied to the base of the first transistor of said basic circuit controls the current through the first transistor which serves as the output signal.

Reference is made to U.S. Patent No. 3,956,641 entitled "Complementary Transistor Circuit for Carrying Out Boolean Functions" granted May 11, 1976 to H. H. Berger et al. The integrated circuit device for carrying out the logical function of at least two input variables is characterized as follows: the transistors employed are bipolar transistors of a first conductivity type and of a second conductivity type opposite to said first conductivity type, the input variables are coupled respectively to the control electrodes of a first transistor of said first conductivity type, and of a second transistor of said second conductivity type provided in the load branch of said first transistor, said bipolar transistors of said first conductivity type and of said second conductivity type having essentially symmetrical switching characteristics, particularly their current gain factors in normal and inverted direction.

For a NOR or NAND function first bipolar transistors arranged in series or parallel, of the one conductivity type, e.g., NPN transistors, are provided, in accordance with the number of input variables. Connected thereto, quasi in the load branch, are an equal number of second bipolar transistors of the opposite conductivity type, e.g., PNP transistors which are combined in parallel or series arrangement. The point of connection of the first and second transistors is the circuit output. The input signals are applied to the respective interconnected control electrodes of two transistors that are complementary to each other.

Reference is made to U.S. Patent No. 4,195,358 entitled "Decoder for a PROM" granted March 25, 1980 to R. C. Yuen. Circuitry for programming a read-only memory comprising a plurality of decoding transistors of low current density for selecting the row of the programmable matrix and which function to operate a high current density control transistor through a large voltage swing for controlling an output transistor of the circuitry connected directly to the array. The decoding transistors are operable through a CML voltage swing in the non-saturated mode with minimum current to operate the control transistor of high current density from cut-off to saturation to turn the output transistor ON or OFF which, in turn, directs the high voltage from a high voltage source to the programmable memory.

Reference is made to U.S. Patent No. 4,200,917 entitled "Quiet Column Decoder" granted April 29, 1980 to J. D. Moench. A quiet column decoder is provided which is useful in semiconductor memory systems. The quiet column decoder prevents glitches from being coupled into the silicon substrate during the period of time that the sense amplifiers are sensing data on the bit sense lines. The quiet column decoder has double clocked NOR gates which allows the address lines to be continuous non-multiplexed lines. The double clocked NOR gate has two transistors for precharging a first and a second node within the NOR gate. Another transistor is coupled between the second node and a voltage reference terminal to serve as an enabling device for the NOR gate. The first node of the NOR gate serves as an output for the column decoder.

Reference is made to the following IBM Technical Disclosure Bulletin Publications:

1. "Self-Biased, Low Voltage, Emitter Followerless Current Switch" by R. J. Blumberg et al., Vol. 16, No. 3, August 1973, page 1017;
2. "Control Signal Generator" by A. Brunin, Vol. 21, No. 1, June 1978, pages 209—210;
3. "Self-Gating, High-Speed Metal-Oxide Semiconductor Decoder" by R. S. Hockedy, Vol. 16, No. 6, November 1973, pages 1922—1923; and
4. "Circuit for Generating Complementary Control Signals" by A. Brunin, Vol. 21, No. 1, June 1978, pages 211—212.

The invention as claimed solves the problem of how to design a logic circuit and decode circuit which performs a complete decode function in only one logic level. One embodiment of the invention is a decoder which produces an UP level output when selected. A second embodiment of the invention is a decoder which produces a DOWN level output when selected. The need for a True/Complement Generator preceding the decode circuit is eliminated through the use of complementary transistors in the decode array. NPN and PNP are employed to produce the desired address outputs. The practice of the invention eliminates the need for high current drivers usually required to drive the high (metallurgy) capacitance of the decode wire matrix since the matrix is now capable of being driven directly by low impedance off chip nets (not shown). The address decode circuit outputs may be buffered by emitter followers and used to select a row and column of an array.

These and other features and advantages of the invention will be apparent from the following more particular description of the preferred embodiment of the invention as illustrated in the accompanying drawings.

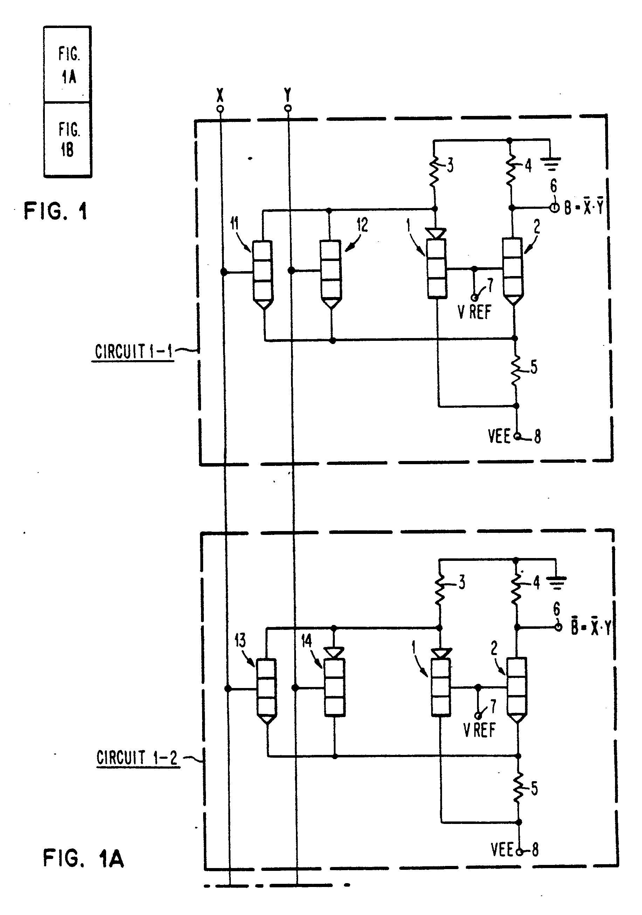

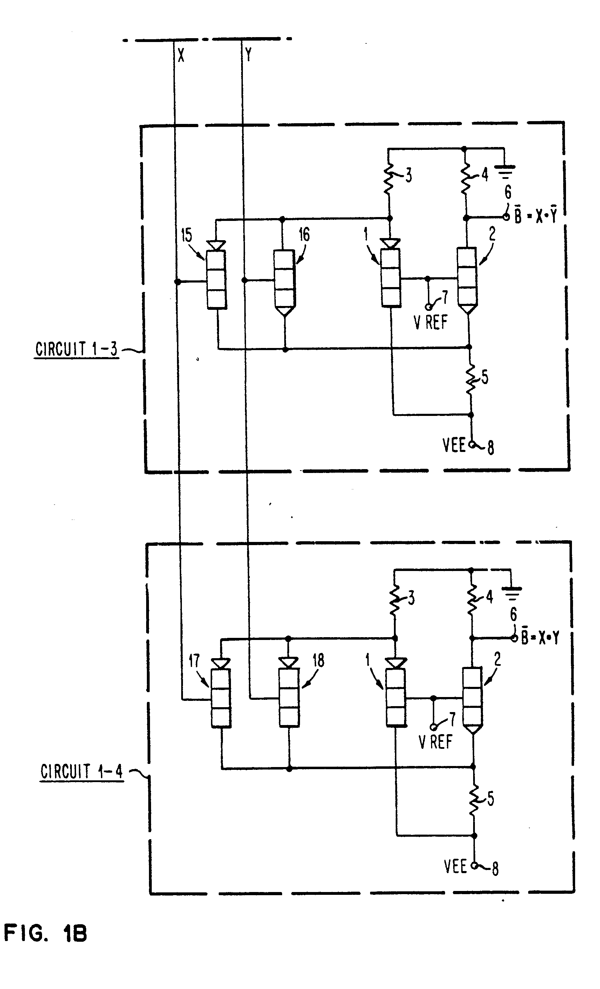

Figures 1A and 1B placed together as shown in Figure 1 disclose a two binary input decode circuit, in accordance with the invention, wherein the selected output (one out of four) is at a DOWN level. Shown in Figure 1 are four similar logic circuits respectively bearing the legends "Circuit 1-1", "Circuit 1-2", "Circuit 1-3" and "Circuit 1-4".

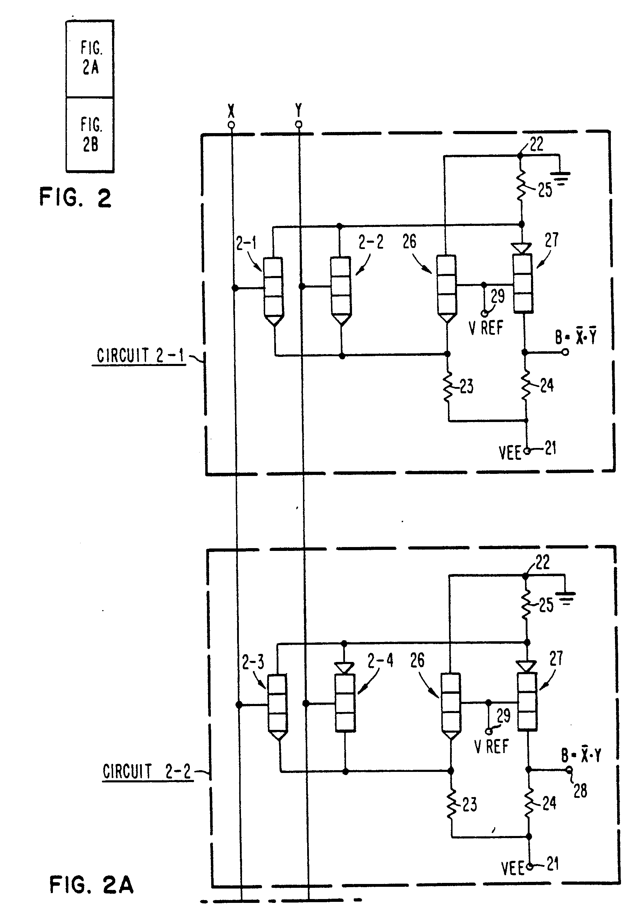

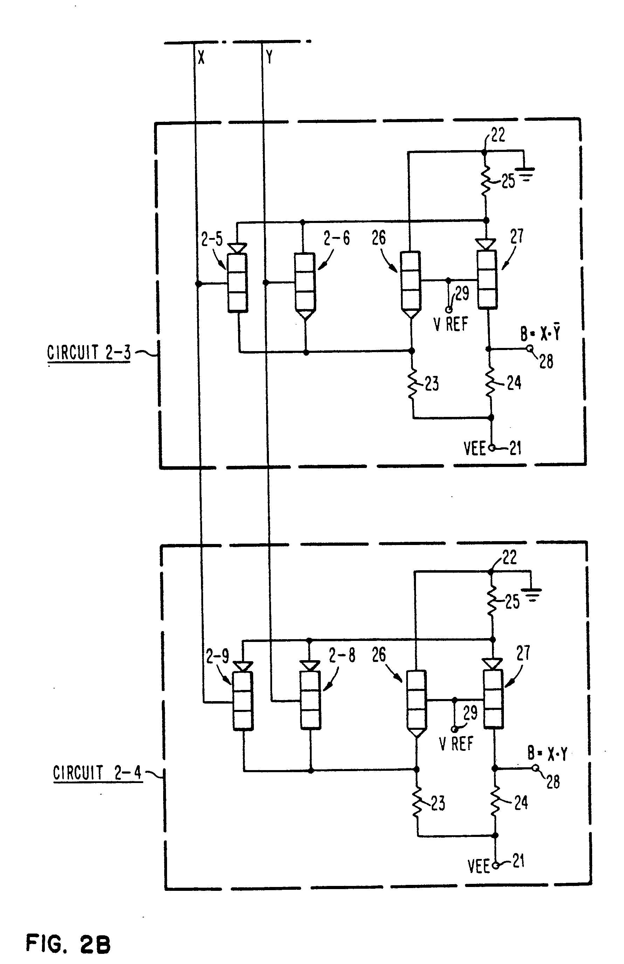

Figures 2A and 2B placed together as shown in Figure 2 disclose a two binary input decode circuit, in accordance with the invention, wherein the selected output (one out of four) is at an UP level. Shown in Figure 2 are four similar logic circuits respectively bearing the legends "Circuit 2-1", "Circuit 2-2", "Circuit 2-3" and "Circuit 2-4".

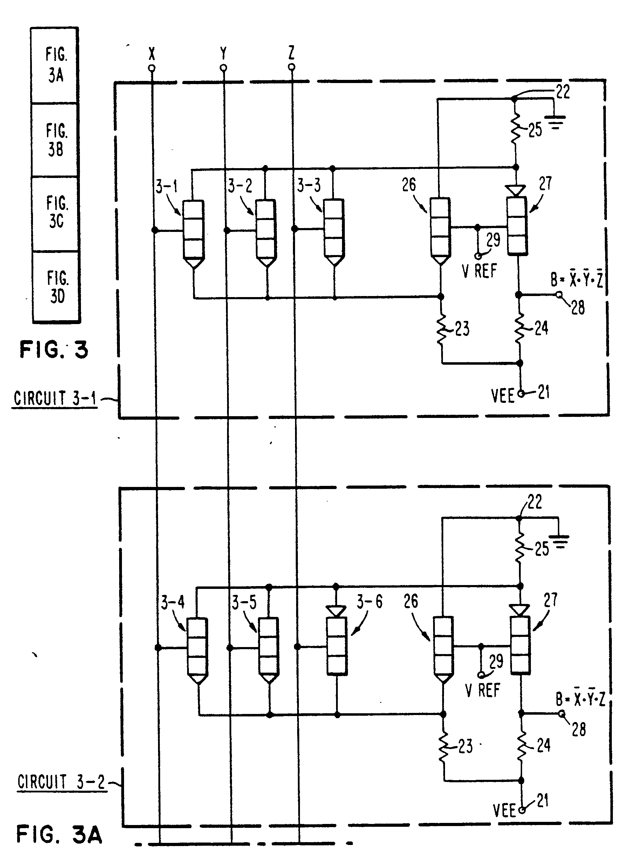

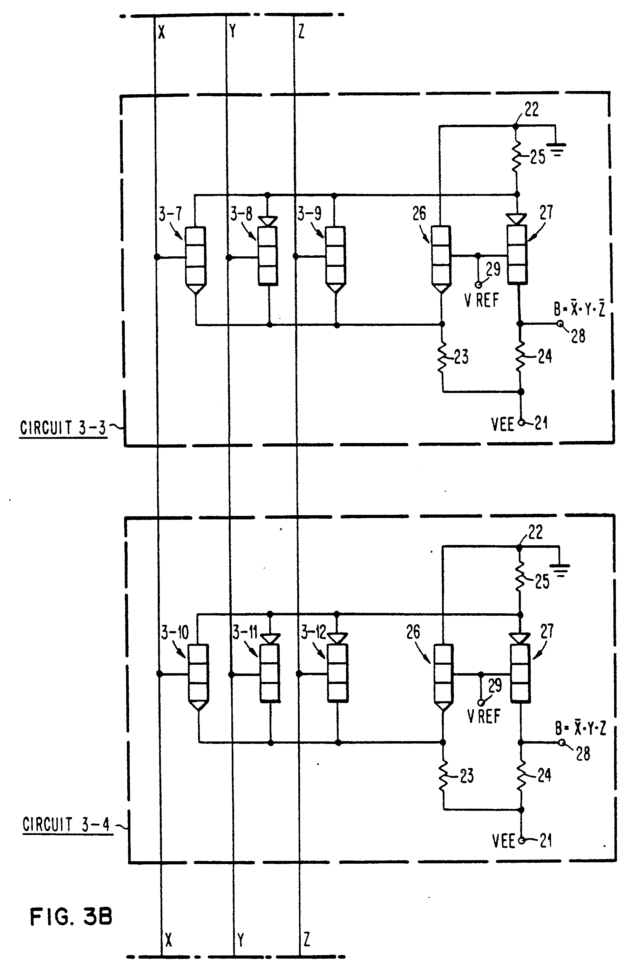

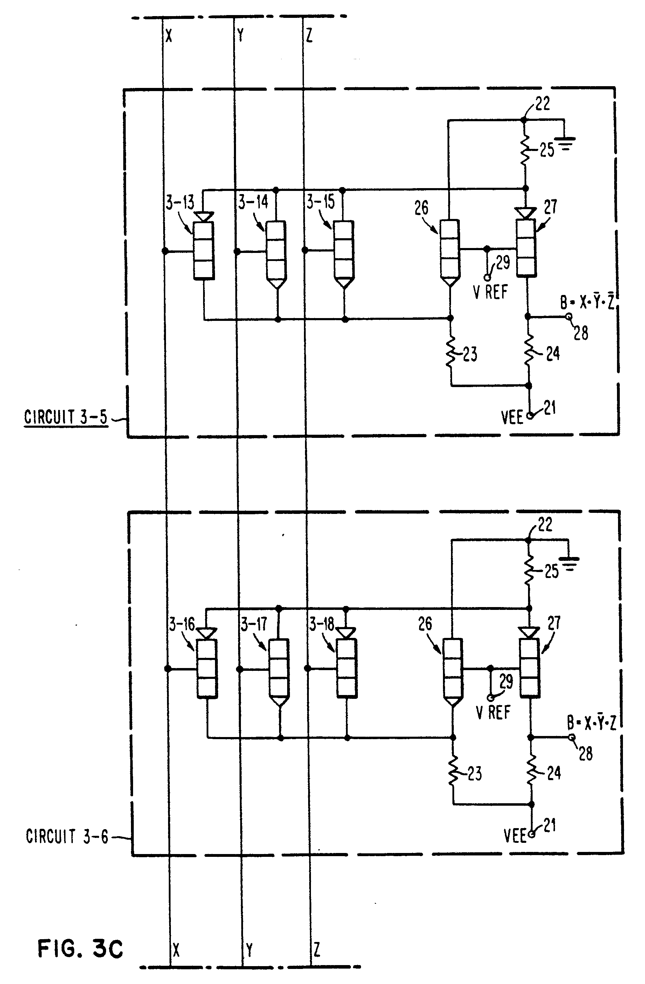

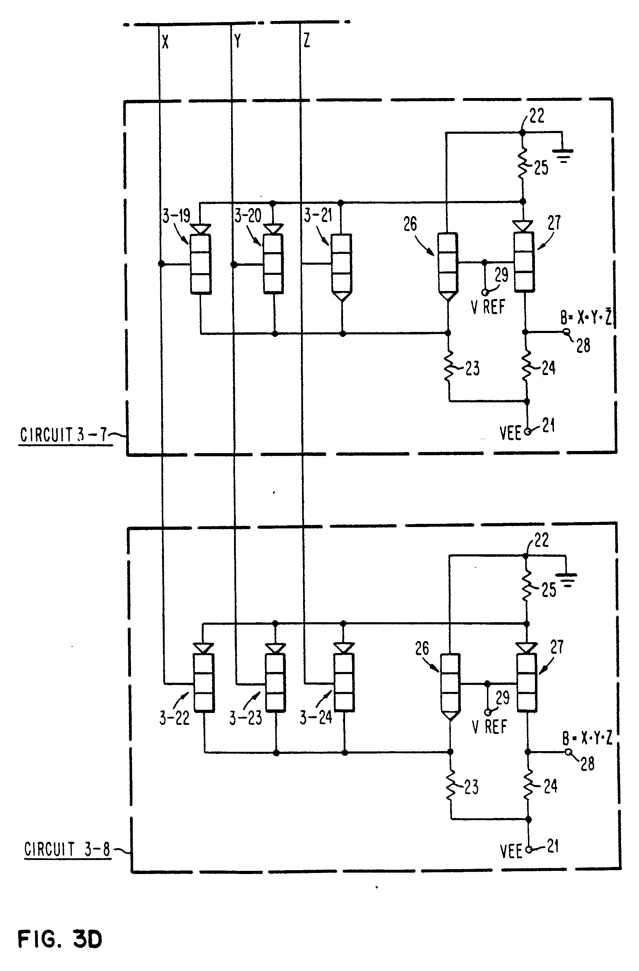

Figures 3A, 3B, 3C and 3D placed together as shown in Figure 3 disclose a three binary input decode circuit, in accordance with the invention, wherein the selected output (one out of eight) is an UP level. Shown in Figure 3 are eight similar logic circuits respectively bearing the legends "Circuit 3-1", "Circuit 3-2"..."Circuit 3-7" and "Circuit 3-8".

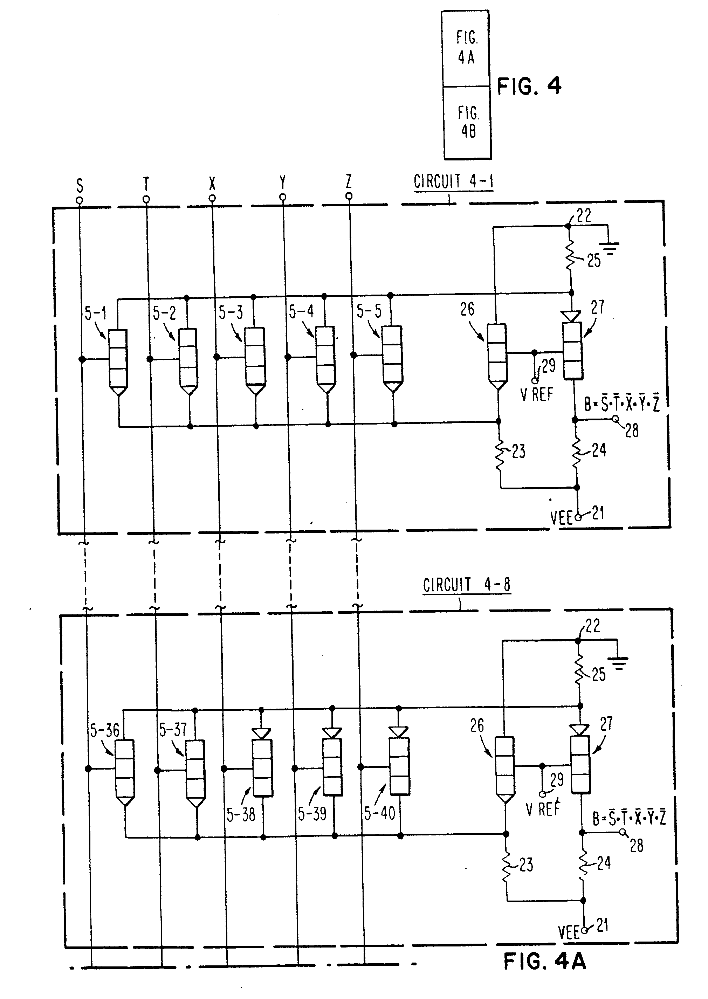

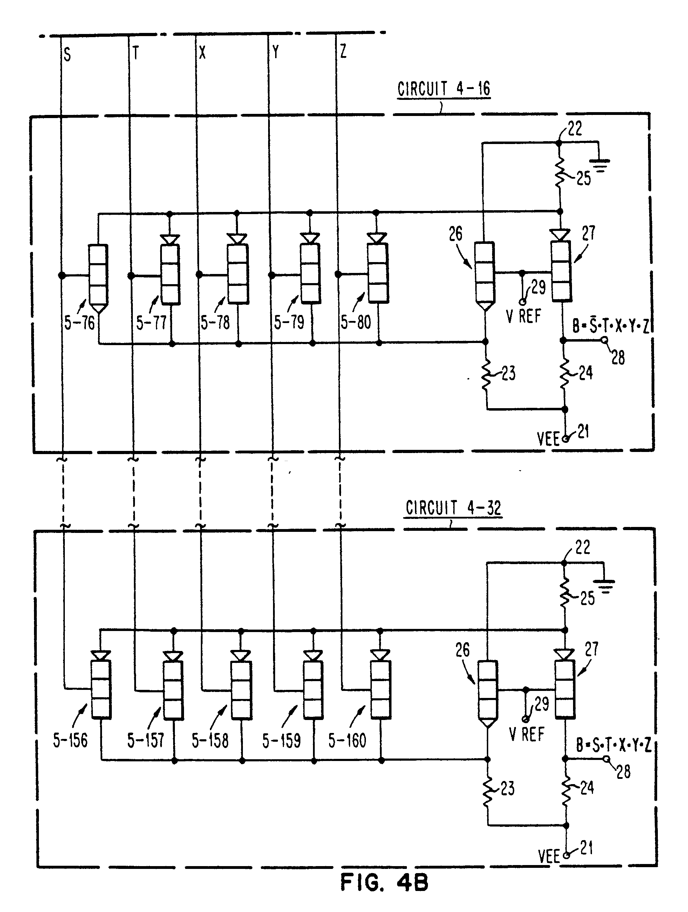

Figures 4A and 4B placed together as shown in Figure 4 depict a five binary input decode circuit, in accordance with the invention, wherein the selected output [one out of thirty-two (only four shown)] is at an UP level. Shown in Figure 4 are only four of the thirty-two similar logic circuits. The four similar logic circuits shown in Figure 4 respectively bear the legends "Circuit 4-1", "Circuit 4-8", "Circuit 4-16" and "Circuit 4-32".

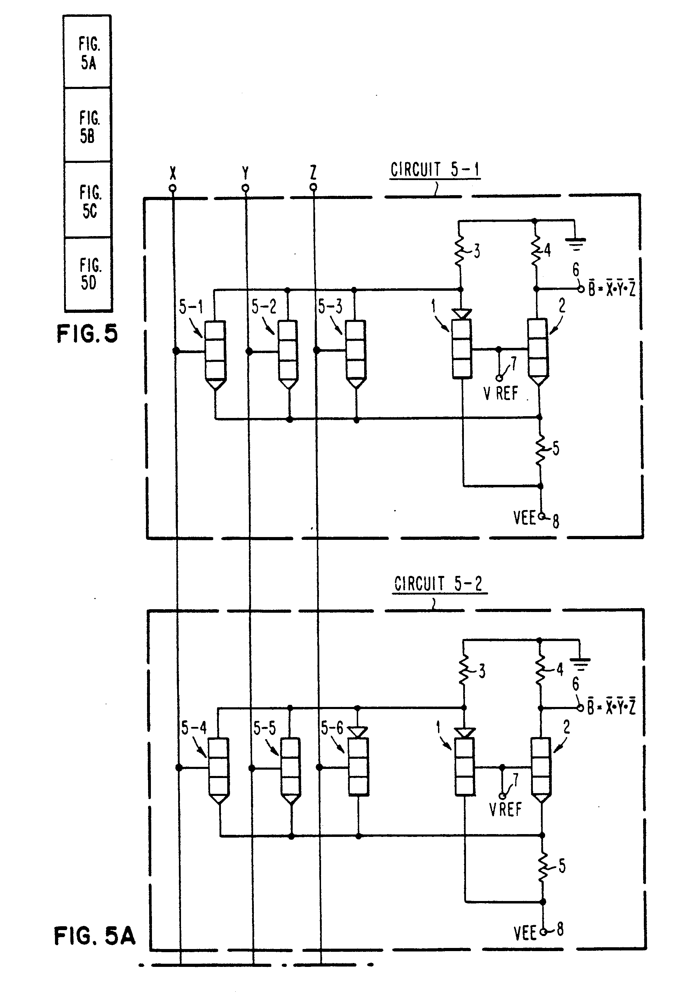

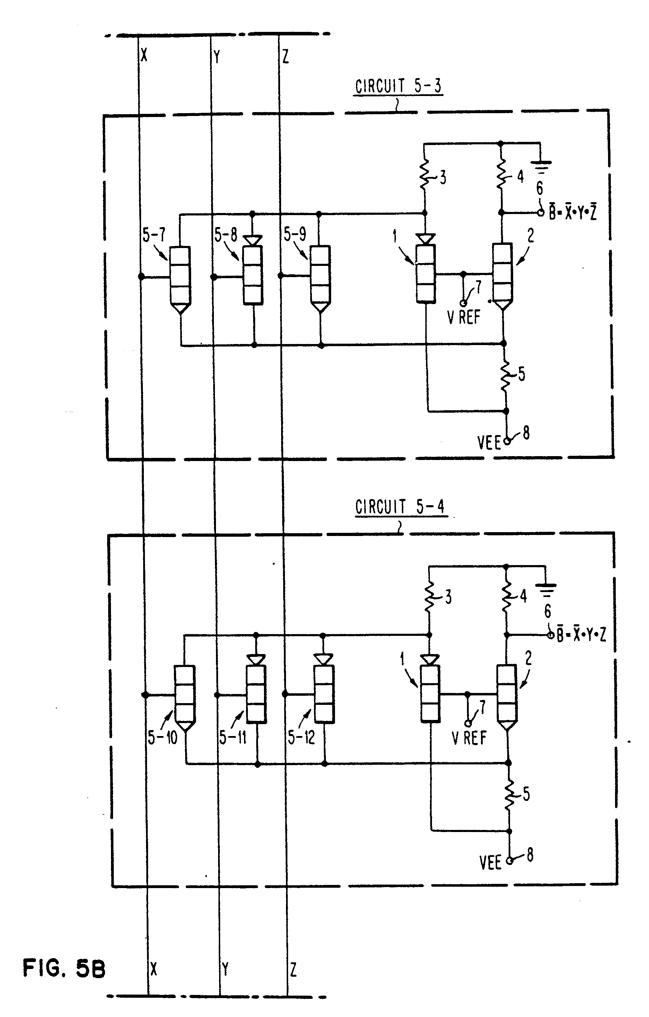

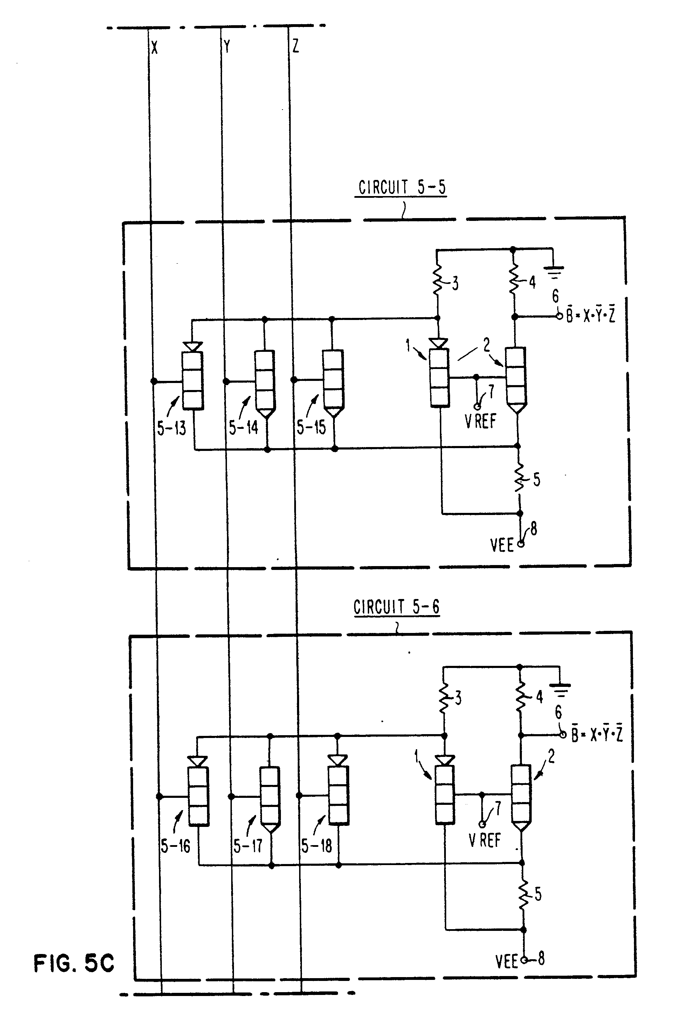

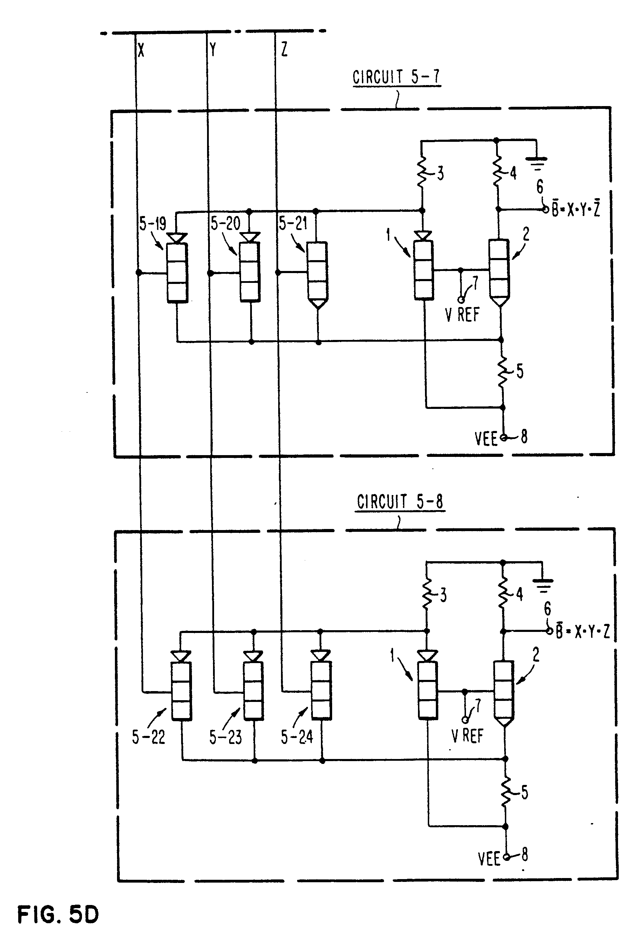

Figures 5A, 5B, 5C and 5D placed together as shown in Figure 5 disclose a three binary input decode circuit, in accordance with the invention, wherein the selected output (one out of eight) is a DOWN level. Shown in Figure 5 are eight similar logic circuits respectively bearing the legends "Circuit 5-1", "Circuit 5-2",..."Circuit 5-7" and "Circuit 5-8".

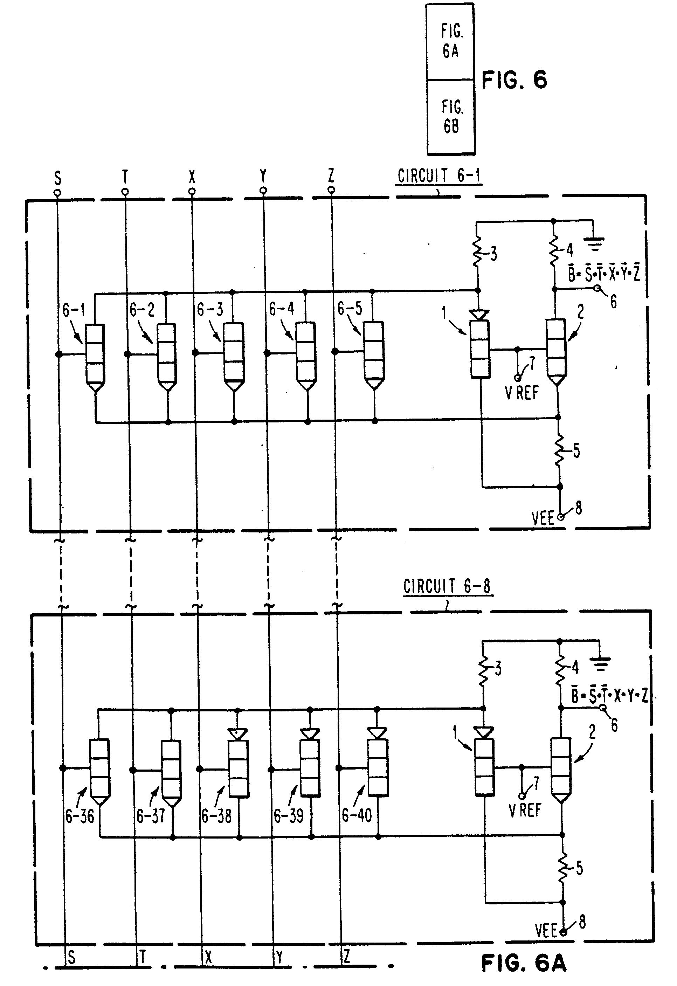

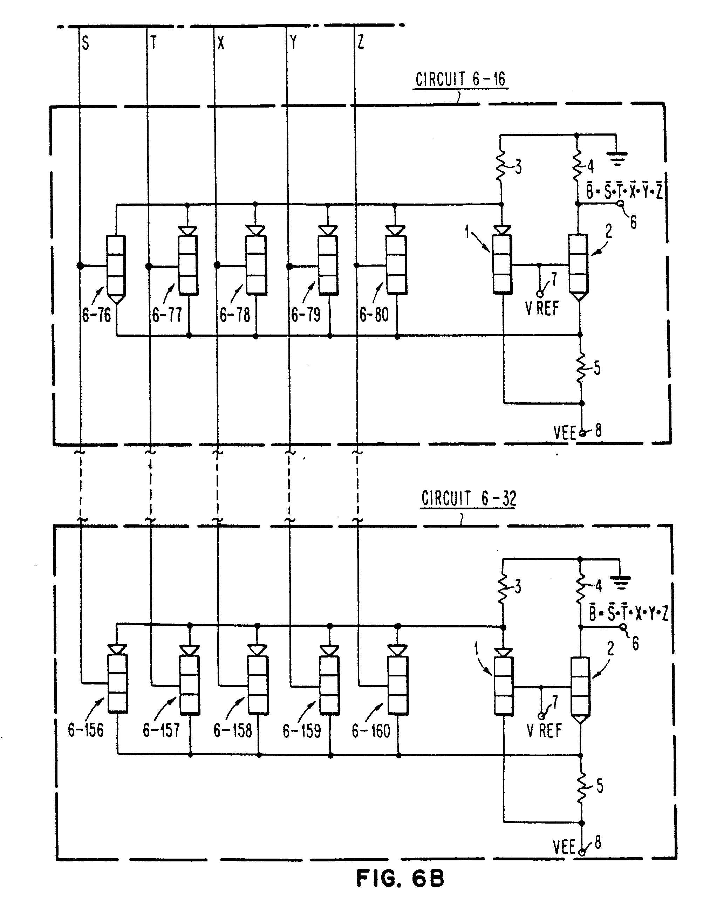

Figures 6A and 6B placed together as shown in Figure 6 depict a five binary input decode circuit, in accordance with the invention, wherein the selected output [one out of thirty-two (only four shown)] is at a DOWN level. Shown in Figure 6 are only four of the thirty-two similar logic circuits. The four similar logic circuits shown in Figure 6 respectively bear the legends "Circuit 6-1", "Circuit 6-8", "Circuit 6-16" and "Circuit 6-32".

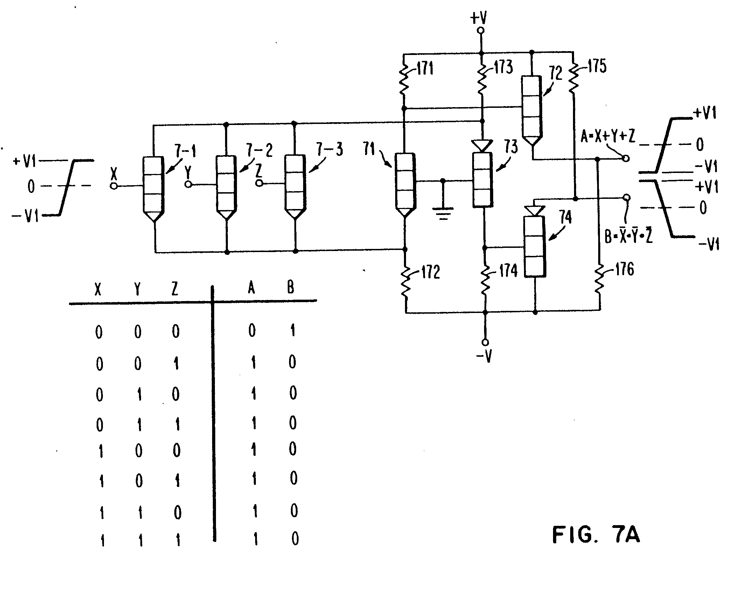

Figure 7A discloses a logical binary circuit for accepting three binary inputs X, Y, Z and providing a true binary output $A=X+Y+Z$ and a complement binary output $B=\overline{X}\cdot\overline{Y}\cdot\overline{Z}$.

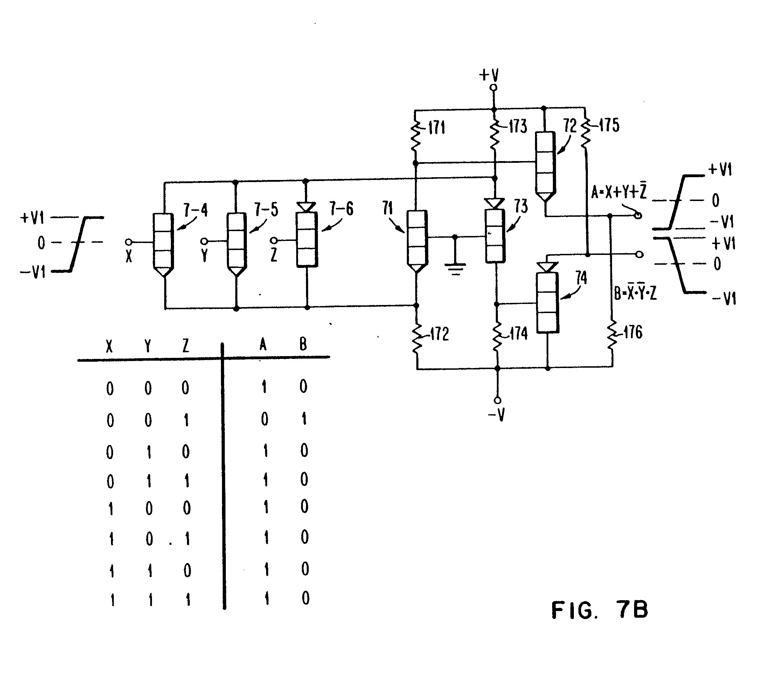

Figure 7B discloses a logical binary circuit for accepting three binary inputs X, Y, Z and providing a true binary output $A=X+Y+\overline{Z}$ and a complement binary output $B=\overline{X}\cdot\overline{Y}\cdot Z$.

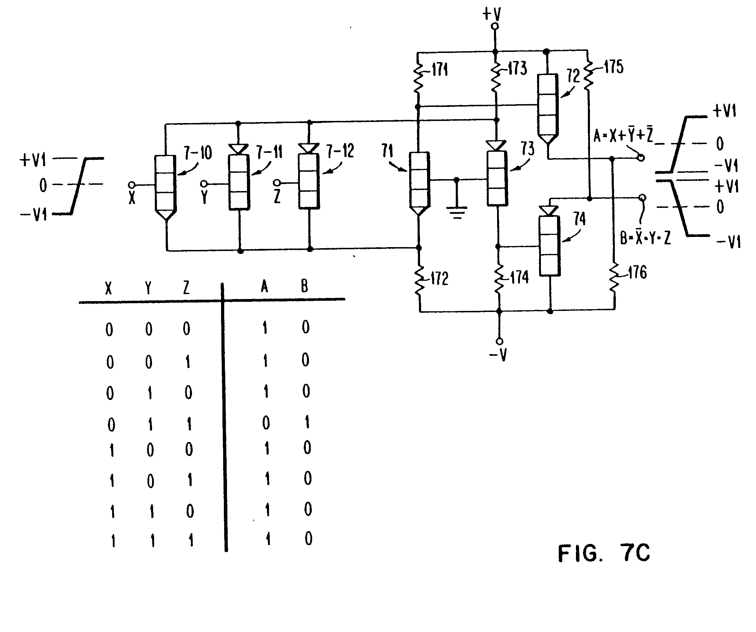

Figure 7C discloses a logical binary circuit for accepting three binary inputs X, Y, Z and providing a true binary output $A=X+\overline{Y}+\overline{Z}$ and a complement binary output $B=\overline{X}\cdot Y\cdot Z$.

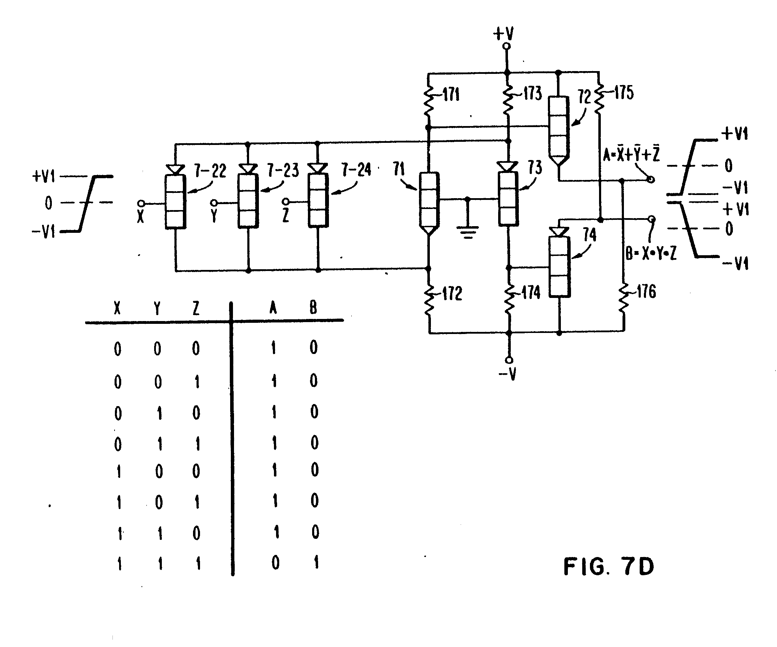

Figure 7D discloses a logical binary circuit for accepting three binary inputs X, Y, Z and providing a true binary output $A=\overline{X}+\overline{Y}+\overline{Z}$ and a complement binary output $B=X\cdot Y\cdot Z$.

The complementary address decode circuit performs a complete decode function in only one logic level. It is depicted in two versions. One version of the decoder, in accordance with the invention (Figures 2, 3 and 4), provides an UP level output when selected. The other version of the decoder in accordance with the invention (Figures 1, 5 and 6) provides a DOWN level output when selected.

Reference is made to Figure 1 of the drawing and to Table No. 1 set-forth below.

TABLE No. 1
(see also decoder of Fig. 1)

| Binary inputs of decoder | | Selected output function | Decoder output $\overline{B}$ | Selected circuit shown in |
|---|---|---|---|---|
| X | Y | | | |
| 0 | 0 | $\overline{X}\cdot\overline{Y}$ | 0 | Fig. 1A (circuit 1-1) |
| 0 | 1 | $\overline{X}\cdot Y$ | 0 | Fig. 1A (circuit 1-2) |
| 1 | 0 | $X\cdot\overline{Y}$ | 0 | Fig. 1B (circuit 1-3) |
| 1 | 1 | $X\cdot Y$ | 0 | Fig. 1B (circuit 1-4) |

Referring to Table No. 1, the left column designates the binary values of ths decode circuit inputs X and Y required to select a designated one of the four outputs of the decoder. The second column from the left in Table No. 1 enumerates the binary output function of each of the four selected outputs. The third column from the left in the Table shows that each of the four selectable outputs, when selected, manifests a binary "0", i.e., a DOWN level. In the right column, the four similar logic circuits of the decode circuit shown in Figure 1 are enumerated by specific figure references together with the legend the circuits bear in the drawing, for example, "Figure 1A (circuit 1-1)", etc.

Still referring to Table No. 1 and the decode circuit of Figure 1, it will be apparent that a decoder binary input of $X=1$ and $Y=0$ will result in the output of logic circuit "Figure 1B (circuit 1-3)" being selected. The selected output will be the logical function $\overline{B}=X\cdot\overline{Y}$. The selected output is at a DOWN level, i.e., binary "0".

Reference is made to Figure 1 and in particular to the logic circuit bearing the reference legend "Circuit 1-3". When the binary inputs to the decoder circuit are $X=1$ and $Y=0$, the base of transistor 15 is more positive than Vref and the base of transistor T16 is more negative than Vref. Accordingly, transistors 15 and 16 will each be "OFF". Transistor 2 will be "ON" and the current through resistor 4 will provide a voltage drop whereby the output terminal 6 (circuit 1-3) will be at a DOWN level, i.e., binary "0".

Still referring to Figure 1 and in particular to the logic circuit bearing reference legend "Circuit 1-3", the operation thereof will be explained in detail below when the binary input to the decode circuit is X=1 and Y=1. When the input to circuit 1-3 is X=1 and Y=1, transistors 15, 1 and 2 will be off and transistor 16 will be on. With Transistor 16 on, current flows from ground, through resistor 3, transistor 16 and resistor 5 into terminal 8. The resulting voltage drop across resistor 5 turns transistor 2 off and output terminal 6 goes to an up level. The resulting voltage drop across resistor 3 turns transistor 1 off.

Still referring to Figure 1 and in particular to the logic circuit bearing the reference legend "Circuit 1-3", the operation thereof will be explained in detail when the binary input to the decode circuit is X=0 and Y=0. When the input to circuit 1-3 is X=0 and Y=0, transistors 15 will be on and transistors 16, 1 and 2 will be off. With transistor 15 on, current flows from ground, through resistor 3, transistor 15 and resistor 5 into terminal 8. The resulting voltage drop across resistor 5 turns transistor 2 off and output terminal 6 goes to an up level. The resulting voltage drop across resistor 3 turns transistor 1 off.

Still referring to Figure 1 and logic "Circuit 1-3", the operation thereof will be explained in detail when the binary input to the decode circuit is X=0 and Y=1. When the input to circuit 1-3 is X=0 and Y=1, both transistor 15 and transistor 16 will be on and transistors 1 and 2 will be off. With both transistors 15 and 16, on, current will flow from ground, through resistor 3, through both transistors 15 and 16 which will ideally each carry half of the current from resistor 3, and through resistor 5 into terminal 8. The resulting voltage drop across resistor 5 turns transistor 2 off and output terminal 6 goes to an up level. The resulting voltage drop across resistor 3 turns transistor 1 off.

Reference is made to Figure 2 of the drawing and to Table No. 2 set-forth below.

TABLE No. 2
(see also decoder of Fig. 2)

| Binary inputs of decoder | | Selected output function | Decoder output B | Selected circuit shown in |
|---|---|---|---|---|
| X | Y | | | |
| 0 | 0 | $\overline{X} \cdot \overline{Y}$ | 1 | Fig. 2A (circuit 2-1) |
| 0 | 1 | $\overline{X} \cdot Y$ | 1 | Fig. 2A (circuit 2-2) |
| 1 | 0 | $X \cdot \overline{Y}$ | 1 | Fig. 2B (circuit 2-3) |
| 1 | 1 | $X \cdot Y$ | 1 | Fig. 2B (circuit 2-4) |

Referring to Table No. 2, the left column designates the binary values of the decode circuit inputs X and Y required to select a designated one of the four outputs of the decode circuit of Figure 2. The second column from the left in Table No. 2 enumerates the binary output function of each of the four selected outputs. The third column from the left in the Table shows that each of the four selectable outputs, when selected manifests a binary "1", i.e., an UP level. In the right column, the four similar logic circuits of the decode circuit shown in Figure 2 are enumerated by specific figure references together with the legend the circuit bears in the drawing, for example, "Figure 2B (Circuit 2-2)", etc.

Still referring to Table No. 2, and the decode circuit of Figure 2 it will be apparent that a decode circuit binary input of X=0 and Y=1 will result in the output of logic circuit Figure 2A (circuit 2-2) to be selected. The selected output will be the logical function $\overline{B}=\overline{X} \cdot Y$. The selected output, which is the output of logic "circuit 2-2" of the decode circuit of Figure 2, will be at the UP level.

Reference is made to Figure 2 and in particular to the logic circuit bearing reference legend "Circuit 2-2". The operation of this logic circuit will be explained in detail below when the binary input to the decode circuit is X=1 and Y=0. When the input to current 2-2 is X=1, Y=0, both transistor 2-3 and transistor 2-4 will be on and transistor 26 and 27 will be off. With both transistors 2-3 and 2-4 on, current will flow from terminal 22, through resistor 25, through both transistors 2-3 and 2-4 which ideally will each carry half of the current from resistor 25, and through resistor 23 into terminal 21. The resulting voltage drop across resistor 25 turns transistor 27 off and output terminal 28 goes to a down level. The resulting voltage drop across resistor 23 turns transistor 26 off.

Still referring to Figure 2 and in particular logic "circuit 2-2", the operation thereof will be explained in detail when the binary input to the decode circuit is X=0 and Y=0. When the input to circuit 2-2 is X=0 and Y=0, transistor 2-3 will be off and transistor 2-4 will be on. With transistor 2-4 on, current will flow from terminal 22, through resistor 25, transistor 2-4 and resistor 23 into terminal 21. The resulting voltage drop across resistor 25 turns transistor 27 off and output terminal 28 goes to a down level. The resulting voltage drop across resistor 23 turns transistor 26 off.

6

Again referring to Figure 2 and in particular logic "circuit 2-2" the operation thereof will be explained in detail when the binary input to the decode circuit is X=1 and Y=1. When the input to circuit 2-2 is X=1 and Y=1, transistor 2-3 will be on and transistor 2-4 will be off. With transistor 2-3 on, current will flow from terminal 22, through resistor 25, transistor 2-3 and resistor 23 into terminal 21. The resulting voltage drop across resistor 25 turns transistor 27 off and output terminal 28 goes to a down level. The resulting voltage drop across resistor 23 turns transistor 26 off.

Reference is made to Figure 3 of the drawing and to Table No. 3 set-forth below.

TABLE No. 3
(see also decoder of Fig. 3)

| Binary inputs of decoder | | | Selected output function | Decoder output B | Selected circuit shown in |
|---|---|---|---|---|---|
| X | Y | Z | | | |
| 0 | 0 | 0 | $\overline{X}\cdot\overline{Y}\cdot\overline{Z}$ | 1 | Fig. 3A (circuit 3-1) |
| 0 | 0 | 1 | $\overline{X}\cdot\overline{Y}\cdot Z$ | 1 | Fig. 3A (circuit 3-2) |
| 0 | 1 | 0 | $\overline{X}\cdot Y\cdot\overline{Z}$ | 1 | Fig. 3B (circuit 3-3) |
| 0 | 1 | 1 | $\overline{X}\cdot Y\cdot Z$ | 1 | Fig. 3B (circuit 3-4) |
| 1 | 0 | 0 | $X\cdot\overline{Y}\cdot\overline{Z}$ | 1 | Fig. 3C (circuit 3-5) |
| 1 | 0 | 1 | $X\cdot\overline{Y}\cdot Z$ | 1 | Fig. 3C (circuit 3-6) |
| 1 | 1 | 0 | $X\cdot Y\cdot\overline{Z}$ | 1 | Fig. 3D (circuit 3-7) |
| 1 | 1 | 1 | $X\cdot Y\cdot Z$ | 1 | Fig. 3D (circuit 3-8) |

In Table No. 3, the left column designates the binary values of the decode circuit input X, Y and Z required to select a designated one of the eight outputs of the decode circuit of Figure 3. The second column from the left in Table No. 3 enumerates the binary output function of each of the eight selectable outputs. The third column from the left in the Table shows that each of the eight selectable outputs, when selected, manifests a binary "1", i.e., an UP level. In the right column, the eight similar logic circuits of the decode circuit shown in Figure 3 are enumerated by specific figure references together with the legend the circuit bears in the drawing for example "Figure 3C (circuit 3-6)", etc.

Still referring to Table No. 3 and the decode circuit of Figure 3 it will be apparent that for a decode circuit binary input of X=1, Y=0 and Z=1 will result in the output of logic circuit of Figure 3C (circuit 3-6) to be selected. The selected output will be the logical function $B=X\,\overline{Y}\,Z$. The selected output, which is the output of logic "circuit 3-6" of the decode circuit of Figure 3, will be at the UP level, i.e., binary "1".

Reference is made to Figure 3 and logic "circuit 3-6". The operation of this logic circuit will be explained in detail below when the binary input to the decode circuit is X=1, Y=0 and Z=1. When the input to circuit 3-6 is X=1, Y=0 and Z=1, transistors 3-16, 3-17 and 3-18 will be off and transistors 26 and 27 will be on. With transistor 27 on, current will flow from terminal 22, through resistor 25, transistor 27 and resistor 24 into terminal 21. The resulting voltage drop across resistor 24 produces an up level at node 28. Current will also flow from terminal 22 through transistor 26 and resistor 23 into terminal 21.

Still referring to Fig. 3 and in particular to logic "circuit 3-6", the operation thereof will be explained in detail when the binary input to the decode circuit is X=1, Y=1 and Z=1. When the input to circuit 3-6 is X=1, Y=1 and Z=1, transistors 3-16, 3-18, 26 and 27 will be off and transistor 3-17 will be on. With transistor 3-17 on, current will flow from terminal 22, through resistor 25, transistor 3-17 and resistor 23 into terminal 21. The resulting voltage drop across resistor 25 turns transistor 27 off and terminal 28 goes to a down level. The resulting voltage drop across resistor 23 turns transistor 26 off.

Still referring to Figure 3 and logic "circuit 3-6" the operation of the decode circuit (in particular logic "circuit 3-6" and logic "circuit 3-7") will be explained in detail when the binary input to the decode circuit is X=1, Y=1 and Z=0. When the input to circuit 3-6 is X=1, Y=1 and Z=0, transistors 3-16, 26 and 27 will be off and transistors 3-17 and 3-18 will be on. With both transistors 3-17 and 3-18 on, current will flow from terminal 22, through resistor 25, through both transistors 3-17 and 3-18, which ideally will each carry half of the current from resistor 25, and through resistor 23 into terminal 21. The resulting voltage drop across resistor 25 turns transistor 27 off and node 28 goes to a down level. The resulting voltage drop across resistor 23 turns transistor 26 off.

When the input to circuit 3-7 is X=1, Y=1 and Z=0, transistors 3-19, 3-20 and 3-21 will be off and transistors 26 and 27 will be on. With transistor 27 on current will flow from terminal 22, into resistor 25, transistor 27 and resistor 24 into terminal 21. The resulting voltage drop across resistor 24 produces and up level at node 28. Current will also flow from terminal 22 through transistor 26 and resistor 23 into terminal 21.

Reference is made to Figure 4 of the drawing and to Table No. 4 set-forth below.

TABLE No. 4
(see also decoder of Fig. 4)

| Binary inputs of decoder | | | | | Selected output function | Decoder output B | Selected circuit shown in |
|---|---|---|---|---|---|---|---|
| S | T | X | Y | Z | | | |
| 0 | 0 | 0 | 0 | 0 | $\overline{S}\cdot\overline{T}\cdot\overline{X}\cdot\overline{Y}\cdot\overline{Z}$ | 1 | Fig. 4 (circuit 4-1) |
| 0 | 0 | 0 | 0 | 1 | $\overline{S}\cdot\overline{T}\cdot\overline{X}\cdot\overline{Y}\cdot Z$ | 1 | (not shown) |
| 0 | 0 | 0 | 1 | 0 | $\overline{S}\cdot\overline{T}\cdot\overline{X}\cdot Y\cdot\overline{Z}$ | 1 | " " |
| 0 | 0 | 0 | 1 | 1 | $\overline{S}\cdot\overline{T}\cdot\overline{X}\cdot Y\cdot Z$ | 1 | " " |
| 0 | 0 | 1 | 0 | 0 | $\overline{S}\cdot\overline{T}\cdot X\cdot\overline{Y}\cdot\overline{Z}$ | 1 | " " |
| 0 | 0 | 1 | 0 | 1 | $\overline{S}\cdot\overline{T}\cdot X\cdot\overline{Y}\cdot Z$ | 1 | " " |
| 0 | 0 | 1 | 1 | 0 | $\overline{S}\cdot\overline{T}\cdot X\cdot Y\cdot\overline{Z}$ | 1 | " " |
| 0 | 0 | 1 | 1 | 1 | $\overline{S}\cdot\overline{T}\cdot X\cdot Y\cdot Z$ | 1 | Fig. 4 (circuit 4-8) |
| 0 | 1 | 0 | 0 | 0 | $\overline{S}\cdot T\cdot\overline{X}\cdot\overline{Y}\cdot\overline{Z}$ | 1 | (not shown) |
| 0 | 1 | 0 | 0 | 1 | $\overline{S}\cdot T\cdot\overline{X}\cdot\overline{Y}\cdot Z$ | 1 | " " |
| 0 | 1 | 0 | 1 | 0 | $\overline{S}\cdot T\cdot\overline{X}\cdot Y\cdot\overline{Z}$ | 1 | " " |
| 0 | 1 | 0 | 1 | 1 | $\overline{S}\cdot T\cdot\overline{X}\cdot Y\cdot Z$ | 1 | " " |
| 0 | 1 | 1 | 0 | 0 | $\overline{S}\cdot T\cdot X\cdot\overline{Y}\cdot\overline{Z}$ | 1 | " " |
| 0 | 1 | 1 | 0 | 1 | $\overline{S}\cdot T\cdot X\cdot\overline{Y}\cdot Z$ | 1 | " " |
| 0 | 1 | 1 | 1 | 0 | $\overline{S}\cdot T\cdot X\cdot Y\cdot\overline{Z}$ | 1 | " " |
| 0 | 1 | 1 | 1 | 1 | $\overline{S}\cdot T\cdot X\cdot Y\cdot Z$ | 1 | Fig. 4 (circuit 4-16) |
| 1 | 0 | 0 | 0 | 0 | $S\cdot\overline{T}\cdot\overline{X}\cdot\overline{Y}\cdot\overline{Z}$ | 1 | (not shown) |
| 1 | 0 | 0 | 0 | 1 | $S\cdot\overline{T}\cdot\overline{X}\cdot\overline{Y}\cdot Z$ | 1 | " " |
| 1 | 0 | 0 | 1 | 0 | $S\cdot\overline{T}\cdot\overline{X}\cdot Y\cdot\overline{Z}$ | 1 | " " |
| 1 | 0 | 0 | 1 | 1 | $S\cdot\overline{T}\cdot\overline{X}\cdot Y\cdot Z$ | 1 | " " |
| 1 | 0 | 1 | 0 | 0 | $S\cdot\overline{T}\cdot X\cdot\overline{Y}\cdot\overline{Z}$ | 1 | " " |
| 1 | 0 | 1 | 0 | 1 | $S\cdot\overline{T}\cdot X\cdot\overline{Y}\cdot Z$ | 1 | " " |
| 1 | 0 | 1 | 1 | 0 | $S\cdot\overline{T}\cdot X\cdot Y\cdot\overline{Z}$ | 1 | " " |
| 1 | 0 | 1 | 1 | 1 | $S\cdot\overline{T}\cdot X\cdot Y\cdot Z$ | 1 | " " |
| 1 | 1 | 0 | 0 | 0 | $S\cdot T\cdot\overline{X}\cdot\overline{Y}\cdot\overline{Z}$ | 1 | " " |

# 0 090 186

TABLE No. 4
(see also decoder of Fig. 4)

| Binary inputs of decoder | | | | | Selected output function | Decoder output B | Selected circuit shown in |
|---|---|---|---|---|---|---|---|
| S | T | X | Y | Z | | | |
| 1 | 1 | 0 | 0 | 1 | $S \cdot T \cdot \overline{X} \cdot \overline{Y} \cdot Z$ | 1 | (not shown) |
| 1 | 1 | 0 | 1 | 0 | $S \cdot T \cdot \overline{X} \cdot Y \cdot \overline{Z}$ | 1 | " " |
| 1 | 1 | 0 | 1 | 1 | $S \cdot T \cdot \overline{X} \cdot Y \cdot Z$ | 1 | " " |
| 1 | 1 | 1 | 0 | 0 | $S \cdot T \cdot X \cdot \overline{Y} \cdot \overline{Z}$ | 1 | " " |
| 1 | 1 | 1 | 0 | 1 | $S \cdot T \cdot X \cdot \overline{Y} \cdot Z$ | 1 | " " |

In Table No. 4, the left column designates the binary values of the decode circuit inputs S, T, X, Y and Z required to select a designated one of the thirty-two (only four shown in Fig. 4) outputs of the decode circuit of Figure 4. The second column from the left in Table No. 4 enumerates the binary output function of each of the thirty-two selectable outputs. The third column from the left in the Table shows that each of the thirty-two selectable outputs when selected, manifests a binary "1", i.e., an UP level. In the right column the thirty-two similar logic circuits of the decode circuit shown in Figure 4 are designated. (However, only four of the thirty-two similar logic circuits are shown in the drawing and expressly identified in Table No. 4 by Figure number and reference legend, namely, "Figure 4A "(circuit 4-1)", "Fig. 4A "(circuit 4-8)", Fig. 4B "(circuit C-16)" and Fig. 4B "(circuit C-24)".

Now referring to Figure 4 and logic "circuit 4-8", the operation of the decode circuit will be explained in detail when the binary input to the decode circuit is S=0, T=0, X=1, Y=1 and Z=1. When the input to circuit 4-8 is S=0, T=0, X=1, Y=1 and Z=1, transistors 5-36, 5-37, 5-38, 5-39 and 5-40 will be off and transistors 26 and 27 will be on. With transistor 27 on, current will flow from terminal 22, through resistor 25, transistor 27 and resistor 24 into terminal 21. The resulting voltage drop across resistor 24 produces an up level at terminal 28. Current will also flow from terminal 22 through transistor 26 and resistor 23 into terminal 21.

In a further reference to Figure 4 and logic "circuit 4-8" the operation of the decode circuit will be explained in detail when the binary input to the decode circuit is S=1, T=0, X=1, Y=1 and Z=1. When the input to circuit 4-8 is S=1, T=0, X=1, Y=1 and Z=1, transistors 5-37, 5-38, 5-39, 5-40, 26 and 27 will be on. With transistor 5-36 on, current will flow from terminal 22, through resistor 25, transistor 5-36 and resistor 23 into terminal 21. The resulting voltage drop across resistor 25 turns transistor 27 off and terminal 28 goes to a down level. The resulting voltage drop across resistor 23 turns transistor 26 off.

In a yet further reference to Figure 4 and logic "circuit 4-8" the operation of the decode circuit will be explained in detail when the binary input to the decode circuit is S=0, T=0, X=1, Y=1 and Z=0. When the input to circuit 4-8 is S=0, T=0, X=1, Y=1 and Z=0, transistors 5-36, 5-37, 5-38, 5-39, 26 and 27 will be off and transistor 5-40 will be on. With transistor 5-40 on, current will flow from terminal 22, through resistor 25, transistor 5-40 and resistor 23 into terminal 21. The resulting voltage drop across resistor 25 turns transistor 27 off and terminal 28 goes to a down level. The resulting voltage drop across resistor 23 turns transistor 26 off.

Reference is made to Figure 5 of the drawing and to Table No. 5 set-forth below.

TABLE No. 5
(see also decoder of Fig. 5)

| Binary inputs | | | Selected output function | Decoder output B | Selected circuit shown in |
|---|---|---|---|---|---|
| X | Y | Z | | | |
| 0 | 0 | 0 | $\overline{X} \cdot \overline{Y} \cdot \overline{Z}$ | 0 | Fig. 5A (circuit 5-1) |
| 0 | 0 | 1 | $\overline{X} \cdot \overline{Y} \cdot Z$ | 0 | Fig. 5A (circuit 5-2) |
| 0 | 1 | 0 | $\overline{X} \cdot Y \cdot \overline{Z}$ | 0 | Fig. 5B (circuit 5-3) |
| 0 | 1 | 1 | $\overline{X} \cdot Y \cdot Z$ | 0 | Fig. 5B (circuit 5-4) |
| 1 | 0 | 0 | $X \cdot \overline{Y} \cdot \overline{Z}$ | 0 | Fig. 5C (circuit 5-5) |
| 1 | 0 | 1 | $X \cdot \overline{Y} \cdot Z$ | 0 | Fig. 5C (circuit 5-6) |
| 1 | 1 | 0 | $X \cdot Y \cdot \overline{Z}$ | 0 | Fig. 5D (circuit 5-7) |
| 1 | 1 | 1 | $X \cdot Y \cdot Z$ | 0 | Fig. 5D (circuit 5-8) |

In Table No. 5 the left column designates the binary values of the decode circuit inputs X, Y and Z required to select a designated one of the eight outputs of the decode circuit of Figure 5. The second column from the left in Table 5 enumerates the binary output function of each of the eight selectable outputs. The third column from the left in the table shows that of the eight selectable outputs, when selected, manifest a binary "0", i.e., a DOWN level. In the right column the eight similar logic circuits of the decode circuit shown in Figure 5 are enumerated by specific figure references together with the legend the circuit bears in the drawing, for example "Fig. 5A (circuit 5-1)", "Fig. 5A (circuit 5-2)", etc.

Now by way of explanation, referring to Figure 5 and Table No. 5, assume the input to the decode circuit is X=0, Y=0 and Z=0. It will be seen that logic "circuit 5-1" of the decoder will be selected to provide the output function $\overline{X} \cdot \overline{Y} \cdot \overline{Z}$ at output $\overline{B}$ thereof. Namely, the output of the selected logic "circuit 5-1" is a binary "0", i.e., DOWN level, whereas the remaining (unselected) seven outputs of the decode circuit are each a binary "1", i.e., an UP level.

Correspondingly, by way of further explanation, still referring to Figure 5 and Table No. 5, when the input to the decode circuit is X=1, Y=1 and Z=0, the logic "circuit 5-7" of the decoder will be selected to provide the output function $X \cdot Y \cdot \overline{Z}$ at output $\overline{B}$ thereof. Namely, the output of the logic "circuit 5-7" is a binary "0", i.e., DOWN level, whereas the remaining seven outputs of the decode circuit are each at a binary "1", i.e., UP level.

Reference is made to Figure 6 of the drawing and to Table No. 6 set-forth below.

TABLE No. 6
(see also decoder of Fig. 6)

| Binary inputs of decoder | | | | | Selected output function | Decoder output B | Selected circuit shown in |
|---|---|---|---|---|---|---|---|
| S | T | X | Y | Z | | | |
| 0 | 0 | 0 | 0 | 0 | $\overline{S} \cdot \overline{T} \cdot \overline{X} \cdot \overline{Y} \cdot \overline{Z}$ | 0 | Fig. 6A (circuit 6-1) |
| 0 | 0 | 0 | 0 | 1 | $\overline{S} \cdot \overline{T} \cdot \overline{X} \cdot \overline{Y} \cdot Z$ | 0 | (not shown) |
| 0 | 0 | 0 | 1 | 0 | $\overline{S} \cdot \overline{T} \cdot \overline{X} \cdot Y \cdot \overline{Z}$ | 0 | " " |
| 0 | 0 | 0 | 1 | 1 | $\overline{S} \cdot T \cdot \overline{X} \cdot Y \cdot Z$ | 0 | " " |
| 0 | 0 | 1 | 0 | 0 | $\overline{S} \cdot \overline{T} \cdot X \cdot \overline{Y} \cdot \overline{Z}$ | 0 | " " |
| 0 | 0 | 1 | 0 | 1 | $\overline{S} \cdot \overline{T} \cdot X \cdot \overline{Y} \cdot Z$ | 0 | " " |
| 0 | 0 | 1 | 1 | 0 | $\overline{S} \cdot \overline{T} \cdot X \cdot Y \cdot \overline{Z}$ | 0 | " " |
| 0 | 0 | 1 | 1 | 1 | $\overline{S} \cdot \overline{T} \cdot X \cdot Y \cdot Z$ | 0 | Fig. 6A (circuit 6-8) |

10

TABLE No. 6
(see also decoder of Fig. 6)

| Binary inputs of decoder | | | | | Selected output function | Decoder output B | Selected circuit shown in |
|---|---|---|---|---|---|---|---|
| S | T | X | Y | Z | | | |
| 0 | 1 | 0 | 0 | 0 | $\overline{S}\cdot T\cdot\overline{X}\cdot\overline{Y}\cdot\overline{Z}$ | 0 | (not shown) |
| 0 | 1 | 0 | 0 | 1 | $\overline{S}\cdot T\cdot\overline{X}\cdot\overline{Y}\cdot Z$ | 0 | „   „ |
| 0 | 1 | 0 | 1 | 0 | $\overline{S}\cdot T\cdot\overline{X}\cdot Y\cdot\overline{Z}$ | 0 | „   „ |
| 0 | 1 | 0 | 1 | 1 | $\overline{S}\cdot T\cdot\overline{X}\cdot Y\cdot Z$ | 0 | „   „ |
| 0 | 1 | 1 | 0 | 0 | $\overline{S}\cdot T\cdot X\cdot\overline{Y}\cdot\overline{Z}$ | 0 | „   „ |
| 0 | 1 | 1 | 0 | 1 | $\overline{S}\cdot T\cdot X\cdot\overline{Y}\cdot Z$ | 0 | „   „ |
| 0 | 1 | 1 | 1 | 0 | $\overline{S}\cdot T\cdot X\cdot Y\cdot\overline{Z}$ | 0 | „   „ |
| 0 | 1 | 1 | 1 | 1 | $\overline{S}\cdot T\cdot X\cdot Y\cdot Z$ | 0 | Fig. 6B (ckt. 6-16) |
| 1 | 0 | 0 | 0 | 0 | $S\cdot\overline{T}\cdot\overline{X}\cdot\overline{Y}\cdot\overline{Z}$ | 0 | (not shown) |
| 1 | 0 | 0 | 0 | 1 | $S\cdot\overline{T}\cdot\overline{X}\cdot\overline{Y}\cdot Z$ | 0 | „   „ |
| 1 | 0 | 0 | 1 | 0 | $S\cdot\overline{T}\cdot\overline{X}\cdot Y\cdot\overline{Z}$ | 0 | „   „ |
| 1 | 0 | 0 | 1 | 1 | $S\cdot\overline{T}\cdot\overline{X}\cdot Y\cdot Z$ | 0 | „   „ |
| 1 | 0 | 1 | 0 | 0 | $S\cdot\overline{T}\cdot X\cdot\overline{Y}\cdot\overline{Z}$ | 0 | „   „ |
| 1 | 0 | 1 | 0 | 1 | $S\cdot\overline{T}\cdot X\cdot\overline{Y}\cdot Z$ | 0 | „   „ |
| 1 | 0 | 1 | 1 | 0 | $S\cdot\overline{T}\cdot X\cdot Y\cdot\overline{Z}$ | 0 | „   „ |
| 1 | 0 | 1 | 1 | 1 | $S\cdot\overline{T}\cdot X\cdot Y\cdot Z$ | 0 | „   „ |
| 1 | 1 | 0 | 0 | 0 | $S\cdot T\cdot\overline{X}\cdot\overline{Y}\cdot\overline{Z}$ | 0 | „   „ |
| 1 | 1 | 0 | 0 | 1 | $S\cdot T\cdot\overline{X}\cdot\overline{Y}\cdot Z$ | 0 | „   „ |
| 1 | 1 | 0 | 1 | 0 | $S\cdot T\cdot\overline{X}\cdot Y\cdot\overline{Z}$ | 0 | „   „ |
| 1 | 1 | 0 | 1 | 1 | $S\cdot T\cdot\overline{X}\cdot Y\cdot Z$ | 0 | „   „ |
| 1 | 1 | 1 | 0 | 0 | $S\cdot T\cdot X\cdot\overline{Y}\cdot\overline{Z}$ | 0 | „   „ |
| 1 | 1 | 1 | 0 | 1 | $S\cdot T\cdot X\cdot\overline{Y}\cdot Z$ | 0 | „   „ |
| 1 | 1 | 1 | 1 | 0 | $S\cdot T\cdot X\cdot Y\cdot\overline{Z}$ | 0 | „   „ |
| 1 | 1 | 1 | 1 | 1 | $S\cdot T\cdot X\cdot Y\cdot Z$ | 0 | Fig. 6B (ckt. 6-32) |

In Table No. 6, the left column designates the binary values of the decode circuit inputs S, T, X, Y and Z required to select a designated one of the thirty-two (only four shown in Fig. 6) outputs of the decode circuit of Figure 6. The second column from the left in Table No. 6 enumerates the binary output function of each of the thirty-two selectable outputs. The third column from the left in the Table shows that each of the thirty-two selectable outputs, when selected, manifests a binary "0", i.e., a DOWN level. In the right column the thirty-two similar logic circuits of the decode circuit shown in Fig. 6 are designed. [However, only four of the thirty-two similar logic circuits are shown in the drawing and expressly identified in Table No. 6 by Figure number and reference legend. Namely, "Fig. 6A (circuit 6-1)", "Fig. 6A (circuit 6-8)", "Fig. 6B (circuit 6-16)" and "Fig. 6B (circuit 6-32)"].

11

Now by way of explanation, referring to Fig. 6 and Table No. 6, assume the input to the decode circuit is S=0, T=0, X=0, U=0 and Z=0. It will be seen that logic "circuit 6-1" of the decoder will be selected to provide the output function $\overline{S} \cdot \overline{T} \cdot \overline{X} \cdot \overline{Y} \cdot \overline{Z}$ at output $\overline{B}$ thereof. Namely, the output of the selected logic "circuit 6-1" is a binary "0", i.e., DOWN level, whereas, the remaining thirty-one (unselected) outputs of the decode circuit are each a binary "1", i.e., an UP level.

Still referring to Figure 6 and Table No. 6, assume the input to the decode circuit is S=0, T=0, X=0, Y=0 and Z=1. It will be apparent that the logic "circuit 6-2" (not shown in Fig. 6) of the decode circuit will be selected to provide the output function $\overline{S} \cdot \overline{T} \cdot \overline{X} \cdot \overline{Y} \cdot Z$ at output $\overline{B}$ thereof. Namely, the output of the selected logical "circuit 6-2" is a binary "0", i.e., DOWN level, whereas the remaining thirty-one (unselected) outputs of the decode circuit are each a binary "1", i.e., an UP level.

Again referring to Figure 6 and Table No. 6, assume the input to the decode circuit is S=0, T=1, X=1, Y=1 and Z=1. It will be apparent that the logic "circuit 6-16" of the decoder will be selected to provide the output function $\overline{S} \cdot T \cdot X \cdot Y \cdot Z$ at output $\overline{B}$ thereof. Namely, the output of the selected logic "circuit 6-16" is a binary "0", i.e., DOWN level, whereas the remaining thirty-one (unselected) outputs of the decode circuit are each a binary "1", i.e., an UP level.

From the foregoing detailed explanation and description of the preferred embodiments of the invention, the following advantages and features will be fully apparent to persons skilled in the art.

Simplified design improves performance

It is generally true that the simpler the design of an integrated circuit, the better the performance. The simple physical and electrical design of this circuit results in improved performance relative to many other decode designs.

May be designed for UP level or DOWN level select

This circuit may be designed to generate either an UP level or a DOWN level at its output when the desired address is present at its input. The very extensive scope of this decoder is a result of the capability of the circuit to be designed to produce OR, NOR, AND, NAND functions.

Complete decoding is accomplished in only one logic level

This decoder established its own switching threshold and performs complete decoding in only one level of logic for minimal circuit delay.

Eliminates the need for a true/complement generator

Complementary NPN, PNP decoding and the ability of this circuit to provide OR, NOR, AND, NAND functions eliminates the need for it to be supplied with both true and complement inputs.

Physical design makes layout simple and efficient

Only two metallurgy lines provide the interconnections to all of the NPN and PNP emitters and collectors. Emitter and collector contacts of NPN and PNP transistors are transposed so that they may be interconnected as required by straight metallurgy lines thus avoiding zig zags and cross-overs in the metallurgy.

Complementary decoding requires only half the number of metal lines over the decoder

Since both true and complement inputs are not required for this decoder, only half of the usual number of metallurgy lines are needed in the decode input wire matrix.

Base inputs provide high impedance for minimal loading of driver circuits

The base circuits of the decoder appear as high impedances to the circuits driving them. The inputs require only microamperes of drive current in both the UP and DOWN levels.

Current source emitter circuits avoid current hogging at inputs

Current source design used in the emitter circuits of both the NPN and PNP transistors avoids base emitter clamping or current hogging of the input address lines when the lines are loaded by more than one decoder.

Decoder may be driven directly from off chip drivers

Decoders are usually driven by true/complement generators located on the same chip. This decoder, however, may be driven directly from off-chip nets, taking advantage of their low impedance and ability to drive the metallurgy capacitance of the decode input wire matrix.

Current mode design eliminates need for antisaturation clamps

By choosing the correct ratio of emitter to collector resistor values, a current mode circuit may be designed to avoid saturation, without the use of anti-saturation clamp diodes. The operating current of the circuit is determined by the value of the emitter resistor while the voltage transition at the collector is determined by the value of the collector load resistor. Thus, the collector load may be designed to keep the circuit out of saturation.

Balanced design makes circuit insensitive to temperature

The balanced current mode design cancels the effect of the Vbe temperature coefficients and guarantees a stable input threshold at all operating temperatures.

Reference voltage may be adjusted for desired input threshold

The current mode configuration of this circuit makes use of a threshold determining reference voltage which may be chosen to provide an input threshold compatible with a variety of driving circuitry.

Operates over a wide power supply voltage range

Current mode operation removes power supply voltage constraints.

May be designed to operate over a wide current range

Circuit current may be designed to provide the desired performance without degradation of stability, reliability or noise margin.

From the preceding detailed description of the invention, it will be apparent to persons skilled in the art that numerous modifications and changes may be made to the decode circuit and logic circuits of the invention without departing from the scope of the invention as claimed. For example, the individual logic circuits of the decode circuit have a utility when employed independent of a decode circuit. The number of inputs of the decode circuit and of the logic circuit are respectively theoretically without limit. The decode circuit, in accordance with the invention, may have, as desired, either an UP level (selected) output or a DOWN level (selected) output. The logic circuit, in accordance with the invention, may have, as desired, either an UP level (selected) output or a DOWN level (selected) output.

Reference is made to the logic circuits of Figures 7A, 7B, 7C and 7D. In Figure 7C, the logic circuit has first, second and third inputs (X, Y, Z) and two emitter follower outputs (A, B). First, second and third NPN transistors (7-10, 71, 72) together with a collector load resistor (171) and an emitter current source (172, −V) provide an NPN current switch emitter follower. First, second, third and fourth PNP transistors (7-11, 7-12, 73, 74) together with a collector load resistor (174) and an emitter current source (173 +V) provide a PNP current switch emitter follower. The collector of the input NPN transistor (7-10) is connected to the emitters of the PNP logic transistors (7-11, 7-12, 73). The collectors of the input PNP transistors are connected to the emitters of the NPN logic transistors (7-10, 71). The collector of the non-inverting NPN transistor (71) is connected to the base of an NPN emitter follower (72) and the collector of the non-inverting PNP transistor (73) is connected to the base of a PNP emitter follower (74). Thus, a dual current switch emitter follower capable of being turned on or off by either the NPN or PNP input transistors is formed. The emitter followers provide low impedance drive, and output logic levels that are compatible with the input threshold.

Collector dotting is not necessary because complementary inputs and dual phase outputs produce OR, NOR, AND, NAND functions in one logic circuit. The desired functions can be extended by adding more, either or both NPN and PNP, input transistors.

It will also be appreciated that a decode circuit may be fabricated by employing a plurality of logic circuits of the type expressly shown in Figures 7A through 7D.

Still referring to Figure 7C, when the inputs to the logic circuit are X=1, Y=1 and Z=1, transistor 7-10 is on and transistors 7-11, 7-12, 71 and 73 are off. With transistor 7-10 on, current flows from terminal +V, through resistor 173, transistor 7-10 and resistor 172 into terminal −V. The resulting voltage drop across resistor 173 turns transistor 73 off and the base of transistor 74 and also output terminal B go down. The resulting voltage drop across resistor 172 turns transistor 71 off and the base of transistor 72 and also output terminal A go up.

When the inputs to the circuit of Figuure 7B are X=1, Y=1 and Z=1, transistors 7-4 and 7-5 are on and transistors 7-6, 71 and 73 are off. With transistors 7-4 and 7-5 on, current flows from terminal +V, through resistor 173 through both transistors 7-4 and 7-5 (which ideally will each carry half of the current from resistor 173) through resistor 172 into terminal −V. The resulting voltage drop across resistor 173 turns transistor 73 off and the base of transistor 74 and also output terminal B go down. The resulting voltage drop across resistor 172 turns transistor 71 off and the base of transistor 72 and also output terminal A go up.

When the inputs to the circuit of Figure 7C are X=0, Y=1 and Z=1, transistors 7-10, 7-11 and 7-12 are off and transistors 71 and 73 are on. With transistors 71 and 73 on, current flows from terminal +V through resistor 171, transistor 71 and resistor 172 into −V. The resulting voltage drop across resistor 171 produces a down level at the base of transistor 72 and also at output terminal A. Current also flows from terminal +V, through resistor 173, transistor 73 and resistor 174 into −V. The resulting voltage drop across resistor 174 produces an up level at the base of transistor 74 and also at output terminal B.

13

# 0 090 186

**Claims**

1. A logic circuit having n inputs (X, Y) for accepting n binary inputs where n is a plural positive integer and having an output terminal (6) for providing as an output a predetermined logical binary function of said n inputs, characterized by

n transistors of a first conductivity type, each of said n transistors having an emitter, base and collector;

an n+1 transistor (2) of said first conductivity type, said n+1 transistor having an emitter, base and collector;

an n+2 transistor (1) of a second conductivity type, said n+2 transistor having an emitter, base and collector;

first passive connection means connecting in common said collectors of said n transistors and said emitter of said n+2 transistor (1);

second passive connection means connecting in common said emitters of said n transistors and said emitter of said n+1 transistor (2);

third passive connection means for respectively connecting each of said n inputs of said logic circuit to the base of a discrete one of said n transistors;

a first resistor (3) connected between said emitter of said n+2 transistor (1) and a first source of potential (ground);

a second resistor (4) connected between said collector of said n+1 transistor (2) and said first source of potential (ground);

a third resistor (5) connected between said emitter of said n+1 transistor (2) and a third source of potential (VEE);

fourth passive connection means connecting said collector of said n+2 transistor (1) to said third source of potential (VEE);

fifth passive connection means connecting said base of said n+1 transistor (2) and said base of said n+2 transistor (1) in common to a second source of potential (V REF); and

said output terminal (6) of said logic circuit being connected to said collector of said n+1 transistor (2).

2. A logic circuit having n inputs (X, Y) for accepting n binary inputs where n is a plural positive integer and having an output terminal (28) for providing as an output a predetermined logical binary function of said n inputs, characterized by n transistors of a first conductivity type, each of said n transistors having an emitter, base and collector;

an n+1 transistor (26) of said first conductivity type, said n+1 transistor having an emitter, base and collector;

an n+2 transistor (27) of a second conductivity type, said n+2 transistor having an emitter, base and collector;

first passive connection means connecting in common said collectors of said n transistors and said emitter of said n+2 transistor (27);

second passive connection means connecting in common said emitters of said n transistors and said emitter of said n+1 transistor (26);

third passive connection means for respectively connecting each of said n inputs of said logic circuit to the base of a discrete one of said n transistors;

a first resistor (25) connected between said emitter of said n+2 transistor (27) and a first source of potential (ground);

a second resistor (24) connected between said collector of said n+2 transistor (27) and a third source of potential (VEE);

a third resistor (23) connected between said emitter of said n+1 transistor (26) and said third source of potenital (VEE);

fourth passive connection means connecting said collector of said n+1 transistor (26) to said first source of potential (ground);

fifth passive connection means connecting said base of said n+1 transistor (26) and said base of said n+2 transistor (27) in common to a second source of potential (V REF); and

said output terminal (28) of said logic circuit being connected to said collector of said n+2 transistor (27).

3. A logic circuit having n inputs (X, Y, Z) for accepting n binary inputs where n is a plural positive integer and having a first output terminal for providing as an output a predetermined logical binary function (A) of said n binary inputs, and a second output terminal for providing as an output the complement (B) of said predetermined logical binary function of said n binary inputs, characterized by

n transistors of a first conductivity type, each of said n transistors having an emitter, base and collector;

an n+1 transistor (71) of said first conductivity type, said n+1 transistor having an emitter, base and collector;

an n+2 transistor (72) of said first conductivity type, said n+2 transistor having an emitter, base and collector, said base of said n+2 transistor (72) being connected to said collector of said n+1 transistor (71);

14

an n+3 transistor (73) of said second conductivity type, said n+3 transistor having an emitter, base and collector;

an n+4 transistor (74) of said second conductivity type, said n+4 transistor having an emitter, base and collector, said base of said n+4 transistor (74) being connected to said collector of said n+3 transistor (73);

first passive connection means connecting in common said collectors of said n transistors (7) and said emitter of said n+3 transistor (73);

second passive connection means connecting in common said emitters of said n transistors and said emitter of said n+1 transistor (71);

third passive connection means for respectively connecting each of said n inputs of said logic circuit to the base of a discrete one of said n transistors (7);

fourth passive connection means for connecting said first output terminal of said logic circuit to said emitter of said n+2 transistor (72);

fifth passive connection means for connecting said second output terminal of said logic circuit to said emitter of said n+4 transistor (74);

a first resistor (171) connected between said collector of said n+1 transistor (71) and a first source of potential (+V);

a second resistor (172) connected between said emitter of said n+1 transistor (71) and a second source of potential (−V);

a third resistor (173) connected between said emitter of said n+3 transistor (73) and said first source of potential (+V);

a fourth resistor (174) connected between said collector of said n+3 transistor (73) and said second source of potential (−V);

a fifth resistor (175) connected between said emitter of said n+4 transistor (74) and said first source of potential (+V);

a sixth resistor (176) connected between said emitter of said n+2 transistor (72) and said second source of potential (−V);

sixth passive connection means for connecting said base of said n+1 transistor (71) and said base of said n+3 traensistor (73) to a source of reference potential (ground); and

additional passive connection means for connecting said collector of said n+2 transistor (72) to said first source of potential (+V) and also connecting said collector of said n+4 transistor (74) to said second source of potential (−V).

4. A logic circuit as claimed in claims 1, 2 or 3 wherein k transistors of said n transistors are of said second conductivity type, whereby n−k of said transistors are of said first conductivity type, where k is a positive interger having a value range of 0, 1, 2,... through n, and wherein said emitters of said k transistors are connected to said first passive connection means, and said collectors of said k transistors are connected to said second passive connection means.

5. A logic circuit as claimed in claims 1 to 4, wherein said first potential source provides a potential V1, said second potential source provides a potential V2, said third potential source provides a potential V3 and the absolute magnitudes of said first, second and third potentials bear the following relationship one to the other, $|V1| < |V2| < |V3|$.

6. A decode circuit, said decode circuit including a plurality of similar logic circuits, each of said similar logic circuits being of the type recited in claims 1 to 5.

**Patentansprüche**

1. Logische Schaltung mit n Eingängen (X, Y) für n binäre Eingangssignale, wobei n eine positive genze Zahl größer als Eins ist, und mit einem Ausgangsanschluß (6), an dem als Ausgang eine bestimmte logische binäre Funktion der n Eingänge geliefert wird, gekennzeichnet durch n Transistoren eines ersten Leitfähigkeitstyps, wobei jeder der n Transistoren einen Emitter, eine Basis und einen Kollektor aufweist:

einen n+1 Transistor (2) des ersten Leitfähigkeitstyps mit einem Emitter, einer Basis und einem Kollektor.

einen n+2 Transistors (1) eines zweiten Leitfähigkeitstyps mit einem Emitter, einer Basis und einem Kollektor,

erste passive Anschlußmittel, welche die Kollektoren der n Transistoren und den Emitter des n+2 Transistors (1) miteinander verbinden,

zweite passive Anschlußmittel, welche die Emitter der n Transistoren im den Emitter des n+1 Transistors (2) miteinander verbinden,

dritte passive Verbindungsmittel zum jeweiligen Verbinden von jedem der n Eingänge der logischen Schaltung mit der Basis eines ausgewählten der n Transistoren,

einen ersten Widerstand (3) zwischen dem Emitter des n+2 Transistors (1) und einer ersten Potentialquelle (Erde),

einem zweiten Widerstand (4) zwischen dem Kollektor des n+1 Transistors (2) und der ersten Potentialquelle (Erde),

einen dritten Widerstand (5) zwischen dem Emitter des n+1 Transistors (2) und einer dritten Potentialquelle (VEE),

15

vierte passive Verbindungsmittel zwischen dem Kollektor des n+2 Transistors (1) und der dritten Potentialquelle (VEE),

fünfte passive Verbindungsmittel, um die Basis des n+1 Transistors (2) und die Basis der n+2 Transistors (1) mit einer zweiten Potentialquelle (V REF) zusammenzuschalten, sowie dem Ausgangsanschluß (6) der logischen Schaltung, welcher mit dem Kollektor des n+1 Transistors (2) verbunden ist.

2. Logische Schaltung mit n Eingängen (X, Y) für n binäre Eingangssignale, wobei n eine positive ganze Zahl größer als Eins ist, und mit einem Ausgangsanschluß (28), an dem als Ausgang eine bestimmte logische binäre Funktion der n Eingänge geliefert wird, gekennzeichnet durch

n Transistoren eines ersten Leitfähigkeitstyps, wobei jeder der n Transistoren einen Emitter, eine Basis und einen Kollektor aufweist,

einen n+1 Transistor (26) des ersten Leitfähigkeitstyps mit einem Emitter, einer Basis und einem Kollektor,

einen n+2 Transistor (27) eines zweiten Leitfähigkeitstyps mit einem Emitter, einer Basis und einem Kollektor,

erste passive Verbindungsmittel, um den Kollektor der n Transistoren und den Emitter des n+2 Transistors (27) untereinander zu verbinden,

zweite passive Verbindungsmittel, um die Emitter der n Transistoren und den Emitter des n+1 Transistors (26) zu verbinden,

dritte passive Verbindungsmittel für das jeweilige Verbinden von jedem der n Eingänge der logischen Schaltung mit der Basis eines bestimmten der n Transistoren,

einen ersten Widerstand (25) zwischen dem Emitter des n+2 Transistors (27) und einer ersten Potentialquelle (Erde),

einen zweiten Widerstand (24) zwischen dem Kollektor des n+2 Transistors (27) und einer dritten Potentialquelle (VEE),

einem dritten Widerstand (23) zwischen dem Emitter des n+1 Transistors (26) und der dritten Potentialquelle (VEE),

vierte passive Verbindungsmittel zur Verbindung des Kollektors des n+1 Transistors (26) mit der ersten Potentialquelle (Erde),

fünfte passive Verbindungsmittel zur Verbindung der Basis des n+1 Transistors (26) und der Basis der n+2 Transistors (27) mit einer zweiten Potentialquelle (V REF) sowie

einer Verbindung des Ausgangsanschlusses (28) der logischen Schaltung mit dem Kollektor des n+2 Transistors (27).

3. Logische Schaltung mit n Eingängen (X, Y, Z) für n binäre Eingangssignale, wobei n eine positive ganze Zahl größer als Eins ist, und mit einem ersten Ausgangsanschluß, an dem als Ausgang eine bestimmte logische binäre Funktion (A) der n binären Eingänge geliefert wird, sowie mit einem zweiten Ausgangsanschluß, an dem als Ausgang das Komplement (B) der bestimmten logischen binären Funktion der n binären Eingänge geliefert wird, gekennzeichnet durch

n Transistoren eines ersten Leitfähigkeitstyps, die jeweils einen Emitter, eine Basis und einen Kollektor aufweisen,

einen n+1 Transistor (71) des ersten Leitfähigkeitstyps mit einem Emitter, einer Basis und einem Kollektor,

einem n+2 Transistor (72) des ersten Leitfähigkeitstyps mit einem Emitter, einer Basis und einem Kollektor, wobei die Basis des n+2 Transistors (72) mit dem Kollektor des n+1 Transistors (71) verbunden ist,

einen n+3 Transistor (73) des zweiten Leitfähigkeitstyps mit einem Emitter, einer Basis und einem Kollektor,

einem n+4 Transistor (74) des zweiten Leitfähigkeitstyps mit einem Emitter, einer Basis und einem Kollektor, wobei die Basis die n+4 Transistors (74) mit dem Kollektor des n+3 Transistors (73) verbunden ist,

erste passive Verbindungsmittel zur gegenseitigen Verbindung der Kollektoren der n Transistoren (7) und der Emitter der n+3 Transistoren (73),

zweite passive Verbindungsmittel zur gegenseitigen Verbindung der Emitter der n Transistoren und des Emitters des n+1 Transistors (71),

dritte passive Verbindungsmittel zum jeweiligen Verbinden von jedem der n Eingänge der logischen Schaltung mit der Basis eines separaten Transistors der n Transistoren (7),

vierte passive Verbindungsmittel zur Verbindung des ersten Ausgangs der logischen Schaltung mit dem Emitter des n+2 Transistors (72),

fünfte passive Verbindungsmittel zur Verbindung des zweiten Ausgangs der logischen Schaltung mit dem Emitter des n+4 Transistors (74),

einen ersten Widerstand (171) zwischen dem Kollektor des n+1 Transistors (71) und einer ersten Potentialquelle (+V),

einen zweiten Widerstand (172) zwischen dem Emitter des n+1 Transistors (71) und einer zweiten Potentialquelle (−V),

einen dritten Widerstand (173) zwischen dem Emitter des n+3 Transistors (73) und der ersten Potentialquelle (+V),

einen vierten Widerstand (174) zwischen dem Kollektor des n+3 Transistors (73) und der zweiten Potentialquelle (−V),

einen fünften Widerstand (175) zwischen dem Emitter des n+4 Transistors (74) und der ersten Potentialquelle (+V),

einen sechsten Widerstand (176) zwischen dem Emitter des n+2 Transistors (72) und der zweiten Potentialquelle (−V),

sechste passive Verbindungsmittel zur Verbindung der Basis des n+1 Transistors (71) und der Basis des n+3 Transistors (73) mit einer Bezugspotentialquelle (Erde) sowie

zusätzliche passive Verbindungsmittel zur Verbindung des Kollektors des n+2 Transistors (72) mit der ersten Potentialquelle (+V) sowie der Verbindung des Kollektors des n+4 Transistors (74) mit der zweiten Potentialquelle (−V).

4. Eine logische Schaltung nach den Ansprüchen 1, 2 oder 3, worin k Transistoren der n Transistoren vom zweiten Leitfähigkeitstyp sind, so daß n−k der Transistoren vom ersten Leitfähigkeitstyp sind, wobei es sich bei k um eine positive ganze Zahl mit einer Wertspanne von 0, 1, 2,... bis n handelt, und wobei die Emitter der k Transistoren mit den ersten passiven Verbindungsmitteln verbunden sind, und die Kollektoren der k Transistoren mit den zweiten passiven Verbindungsmitteln verbunden sind.

5. Eine logische Schaltung nach den Ansprüchen 1 bis 4, worin die erste Potentialquelle ein Potential V1, die zweite Potentialquelle ein Potential V2, und die dritte Potentialquelle ein Potential V3 liefert, und wo die absoluten Magnituden der ersten, zweiten und dritten Potentiale in folgendem Verhältnis zueinander stehen: $|V1| < |V2| < |V3|$.

6. Decodierungsschaltung, mit mehreren ähnlichen logischen Schaltungen gemäß den Ansprüchen 1 bis 5.

## Revendications

1. Circuit logique comportant n entrées (X, Y) pour recevoir n entrées binaires, n étant un nombre entier positif non unité, et comportant une borne de sortie (6) pour fournir comme sortie une fonction binaire logique prédéterminée desdites n entrées, caractérisé par n transistors d'un premier type de condu••ivité, chacun de ces n transistors comportant un émetteur, une base et un collecteur; un n+1 tran•• ••r (2) dudit premier type de conductivité, ce n+1 transistor comportant un émetteur, une base et un col•• ••r; un n+2 transistor (1) d'un deuxième type de conductivité, ce n+2 transistor comportant un émetteur, une base et un collecteur; des premiers moyens de connexion passive reliant en commun lesdits collecteurs desdits n transistors et ledit émetteur dudit n+2 transistor (1); des deuxièmes moyens de connexion passive reliant en commun lesdits émetteurs desdits n transistors et ledit émetteur dudit n+1 transistor (2); des troisièmes moyens de connexion passive pour relier respectivement chacune desdites n entrées dudit circuit logique à la base d'un transistor séparé parmi lesdits n transistors; une première résistance (3) branchée entre ledit émetteur dudit n+2 transistor (1) et une première source de potentiel (terre); une deuxième résistance (4) branchée entre ledit collecteur dudit n+1 transistor (2) et ladite première source de potentiel (terre); une troisième résistance (5) branchée entre ledit émetteur dudit n+1 transistor (2) et une troisième source de potentiel (VEE); des quatrièmes moyens de connexion passive reliant ledit collecteur dudit n+2 transistor (1) à ladite troisième source de potentiel (VEE); des cinquièmes moyens de connexion passive reliant ladite base dudit n+1 transistor (2) et ladite base dudit n+2 transistor (1) en commun à une deuxième source de potentiel (V REF); et ladite borne de sortie (6) dudit circuit logique étant connectée dudit collecteur dudit n+1 transistor (2).

2. Circuit logique comportant n entrées (X, Y) pour recevoir n entrées binaires, n étant un nombre entier positif supérieur à l'unité, et comportant une borne de sortie (28) pour fournir comme sortie une fonction binaire logique prédéterminée desdites n entrées, caractérisé par n transistors d'un premier type de conductivité, chacun de ces n transistors comportant un émetteur, une base et un collecteur, un n+1 transistor (26) dudit premier type de conductivité, ce n+1 transistor comportant un émetteur, une base et un collecteur; un n+2 transistor (27) d'un deuxième type de conductivité, ce n+2 transistor comportant un émetteur, une base et un collecteur; des premiers moyens de connexion passive reliant en commun lesdits collecteurs desdits n transistors et ledit émetteur dudit n+2 transistors (27); des deuxièmes moyens de connexion passive reliant en commun lesdits émetteurs desdits n transistors et ledit émetteur dudit n+1 transistor (26); des troisièmes moyens de connexion passive pour relier respectivement chacune desdites n entrées dudit circuit logique à la base d'un transistor distinct parmi lesdits n transistors; une première résistance (25) branchée entre ledit émetteur dudit n+2 transistor (27) et une première source de potentiel (terre); une deuxième résistance (24) branchée entre ledit collecteur dudit n+2 transistor (27) et une troisième source de potentiel (VEE); une troisième résistance (23) branchée entre ledit émetteur dudit n+1 transistor (26) et ladite troisième source de potentiel (VEE); des quatrièmes moyens de connexion passive reliant ledit collecteur dudit n+1 transistor (26) à ladite première source de potentiel (terre); des cinquièmes moyens de connexion passive reliant ladite base dudit n+1 transistor (26) et ladite base dudit n+2 transistor (27) en commun à une deuxième source de potentiel (V REF); et ladite borne de sortie (28) dudit circuit logique étant reliée audit collecteur dudit n+2 transistor (27).

17

**0 090 186**

3. Circuit logique comportant n entrées (X, Y, Z) pour recevoir n entrées binaires, n étant un nombre entier positif supérieur à l'unité, et comportant une première borne de sortie pour fournir comme sortie une fonction binaire logique prédéterminée (A) desdites n entrées binaires, et une deuxième borne de sortie pour fournir comme sortie le complément (B) de ladite fonction binaire logique prédéterminée desdites n entrées binaires, caractérisé par n transistors d'un premier type de conductivité, chacun de ces n transistors comportant un émetteur, une base et un collecteur; un n+1 transistor (71) dudit premier type de conductivité, ce n+1 transistor comportant un émetteur, une base et un collecteur; un n+2 transistor (72) dudit premier type de conductivité, ce n+2 transistor comportant un émetteur, une base et un collecteur, ladite base dudit n+2 transistor (72) étant connectée audit collecteur dudit n+1 transistor (71); un n+3 transistor (73) dudit deuxième type de conductivité, ce n+3 transistor comportant un émetteur, une base et un collecteur; un n+4 transistor (74) dudit deuxième type de conductivité, ce n+4 transistor comportant un émetteur, une base et un collecteur, ladite base dudit n+4 transistor (74) étant reliée audit collecteur dudit n+3 transistor (73); des premiers moyens de connexion passive reliant en commun lesdits collecteurs des dits n transistors (7) et ledit émetteur dudit n+3 transistor (73); des deuxièmes moyens de connexion passive reliant en commun lesdits émetteurs desdits n transistors et ledit émetteur dudit n+1 transistor (71); des troisièmes moyens de connexion passive pour relier respectivement chacune desdites n entrées dudit circuit logique à la base d'un transistor distinct parmi lesdits n transistors (7); des quatrièmes moyens de connexion passive pour relier ladite première borne de sortie dudit circuit logique audit émetteur dudit n+2 transistor (72); des cinquièmes moyens de connexion passive pour relier ladite deuxième borne de sortie dudit circuit logique audit émetteur dudit n+4 transistor (74); une première résistance (171) branchée entre ledit collecteur dudit n+1 transistor (71) et une première source de potentiel (+V); une deuxième résistance (172) branchée entre ledit émetteur dudit n+1 transistor (71) et une deuxième source de potentiel (−V); une troisième résistance (173) branchée entre ledit émetteur dudit n+3 transistor (73) et ladite première source de potentiel (+V), une quatrième résistance (174) branchée entre ledit collecteur dudit n+3 transistor (73) et ladite deuxième source de potentiel (−V); une cinquième résistance (175) branchée entre ledit émetteur dudit n+4 transistor (74) et la dite première source de potentiel (+V); une sixième résistance (176) branchée entre ledit émetteur dudit n+2 transistor (72) et ladite deuxième source de potentiel (−V): des sixièmes moyens de connexion passive pour relier ladite base dudit n+1 transistor (71) et ladite base dudit n+3 transistor (73) à une source de potentiel de référence (terre); et des moyens additionnels de connexion passive pour relier ledit collecteur dudit n+2 transistor (72) à ladite première source de potentiel (+V) et pour relier également ledit collecteur dudit n+4 transistor (74) à ladite deuxième source de potentiel (−V).

4. Circuit logique suivant les revendications 1, 2 ou 3, dans lequel k transistors desdits n transistors sont dudit deuxième type de conductivité, de sorte que n−k desdits transistors sont dudit premier type de conductivité, k étant un nombre entier positif dans une plage de valeur de 0, 1, 2,... à n, et dans lequel lesdits émetteurs des dits k transistors sont reliés auxdits premiers moyens de connexion passive et lesdits collecteurs desdits k transistors sont reliés auxdits deuxièmes moyens de connexion passive.

5. Circuit logique suivant les revendications 1 à 4, dans lequel ladite première source de potentiel fournit un potentiel V1, ladite deuxième source de potentiel fournit un potentiel V2, ladite troisième source de potentiel fournit un potentiel V3 et les valeurs absolues desdits premier, deuxième et troisième potentiels vérifient la relation suivante les unes par rapport aux autres, $|V1| < |V2| < |V3|$.

6. Circuit de décodage, ledit circuit de décodage comprenant une pluralité de circuits logiques similaires, chacun de ces circuits logiques similaires étant du type indiqué dans les revendications 1 à 5.

FIG.
1A

FIG.
1B

FIG. 1

X    Y

3    4

6
B = X̄·Ȳ

11    12    1    2

7
V REF

CIRCUIT 1-1

5

VEE  8

3    4

6
B̄ = X̄·Y

13    14    1    2

7
V REF

CIRCUIT 1-2

5

VEE  8

FIG. 1A

1

FIG. 1B

FIG. 2

FIG. 2A

3

FIG. 2B

# 0 090 186

FIG. 3

CIRCUIT 3-1

FIG. 3A

CIRCUIT 3-2

$B = \bar{X} \cdot \bar{Y} \cdot \bar{Z}$

$B = \bar{X} \cdot \bar{Y} \cdot Z$

V REF

VEE

5

FIG. 3B

FIG. 3C

7

FIG. 3D

0 090 186

FIG. 4

FIG. 4A

FIG. 4B

CIRCUIT 4-1

CIRCUIT 4-8

$B = \bar{S} \cdot \bar{T} \cdot \bar{X} \cdot \bar{Y} \cdot \bar{Z}$

V REF

VEE

FIG. 4A

FIG. 4B

0 090 186

10

FIG. 5

FIG. 5A

CIRCUIT 5-3

$\bar{B} = \bar{X} \cdot Y \cdot \bar{Z}$

CIRCUIT 5-4

$\bar{B} = \bar{X} \cdot Y \cdot Z$

**FIG. 5B**

CIRCUIT 5-5

CIRCUIT 5-6

FIG. 5C

CIRCUIT 5-7

$\bar{B} = X \cdot Y \cdot \bar{Z}$

V REF

VEE

CIRCUIT 5-8

$\bar{B} = X \cdot Y \cdot Z$

V REF

VEE

FIG. 5D

14

0 090 186

FIG. 6

FIG. 6A

FIG. 6B

CIRCUIT 6-1

$\bar{B} = \bar{S} \cdot \bar{T} \cdot \bar{X} \cdot \bar{Y} \cdot \bar{Z}$

V REF

VEE

CIRCUIT 6-8

$\bar{B} = \bar{S} \cdot \bar{T} \cdot X \cdot Y \cdot Z$

V REF

VEE

FIG. 6A

15

FIG. 6B

16

FIG. 7A

FIG. 7B

| X | Y | Z | A | B |
|---|---|---|---|---|
| 0 | 0 | 0 | 1 | 0 |
| 0 | 0 | 1 | 1 | 0 |
| 0 | 1 | 0 | 1 | 0 |
| 0 | 1 | 1 | 0 | 1 |
| 1 | 0 | 0 | 1 | 0 |
| 1 | 0 | 1 | 1 | 0 |
| 1 | 1 | 0 | 1 | 0 |
| 1 | 1 | 1 | 1 | 0 |

$A = X + \bar{Y} + \bar{Z}$

$B = \bar{X} \cdot Y \cdot Z$

FIG. 7C

FIG. 7D

| X | Y | Z | A | B |
|---|---|---|---|---|
| 0 | 0 | 0 | 1 | 0 |
| 0 | 0 | 1 | 1 | 0 |
| 0 | 1 | 0 | 1 | 0 |
| 0 | 1 | 1 | 1 | 0 |
| 1 | 0 | 0 | 1 | 0 |
| 1 | 0 | 1 | 1 | 0 |
| 1 | 1 | 0 | 1 | 0 |
| 1 | 1 | 1 | 0 | 1 |